(19) Europäisches Patentamt
European Patent Office
Office européen des brevets

(11) **EP 3 019 634 B1**

(12) **EUROPÄISCHE PATENTSCHRIFT**

(45) Veröffentlichungstag und Bekanntmachung des Hinweises auf die Patenterteilung:
**31.05.2017 Patentblatt 2017/22**

(21) Anmeldenummer: **14737250.2**

(22) Anmeldetag: **09.07.2014**

(51) Int Cl.:
*C21C 5/46* (2006.01)      *C21C 5/52* (2006.01)
*F27D 3/16* (2006.01)      *G06F 17/50* (2006.01)
*F27B 3/22* (2006.01)

(86) Internationale Anmeldenummer:
**PCT/EP2014/064713**

(87) Internationale Veröffentlichungsnummer:
**WO 2015/004182 (15.01.2015 Gazette 2015/02)**

(54) **INJEKTOR ZUM EINSATZ IN METALLURGISCHEN ANLAGEN**

INJECTOR FOR USE IN METALLURGICAL PLANTS

INJECTEUR DESTINÉ À ÊTRE UTILISÉ DANS DES INSTALLATIONS MÉTALLURGIQUES

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 12.07.2013 DE 102013213738
25.10.2013 DE 102013221749
16.12.2013 DE 102013226109

(43) Veröffentlichungstag der Anmeldung:
**18.05.2016 Patentblatt 2016/20**

(73) Patentinhaber: **SMS group GmbH**
**40237 Düsseldorf (DE)**

(72) Erfinder:
• ODENTHAL, Hans-Jürgen
40822 Mettmann (DE)
• KLIOUTCHNIKOV, Igor
52062 Aachen (DE)
• OLIVIER, Herbert
52072 Aachen (DE)

(74) Vertreter: **Klüppel, Walter**
**Hemmerich & Kollegen**
**Patentanwälte**
**Hammerstraße 2**
**57072 Siegen (DE)**

(56) Entgegenhaltungen:
WO-A1-2011/120976      US-B1- 6 342 086
US-B2- 7 452 401

• KLIOUTCHNIKOV I ET AL: "Numerical investigation of coaxial jets entering into a hot environment", COMPUTERS AND FLUIDS, [Online] Bd. 86, 12. August 2013 (2013-08-12), Seiten 490-499, XP028718083, ISSN: 0045-7930, DOI: 10.1016/J.COMPFLUID.2013.07.032
• MURAKAMI E ET AL: "Mean flow development in dual-stream compressible jets", AIAA JOURNAL AIAA USA, [Online] Bd. 40, Nr. 6, Juni 2002 (2002-06), Seiten 1131-1138, XP002731467, ISSN: 0001-1452 Gefunden im Internet: URL:http://arc.aiaa.org/doi/abs/10.2514/2. 1762> [gefunden am 2014-10-21]
• IKUHIRO SUMI ET AL: "Effect of High-temperature Field on Supersonic Oxygen Jet Behavior", ISIJ INTERNATIONAL, Bd. 46, Nr. 9, 1. Januar 2006 (2006-01-01) , Seiten 1312-1317, XP055148278, ISSN: 0915-1559, DOI: 10.2355/isijinternational.46.1312

## Beschreibung

Technisches Gebiet

Die vorliegende Erfindung betrifft einen Injektor zum Einsatz in metallurgischen Anlagen insbesondere in einem Basic Oxygen Furnace (BOF), in einem Argon Oxygen Decarburization (AOD) Konverter oder in einem Elektrolichtbogenofen (EAF), mit einer als Überschalldüse ausgelegten Primärdüse zum Aufblasen eines sauerstoffreichen Gases auf eine Metallschmelze und einer koaxial zur Primärdüse angeordneten Sekundärdüse zum Erzeugen eines den aus der Primärdüse austretenden Gasstrahl umgebenden Koaxialstrahls.

Stand der Technik

Aus dem Stand der Technik sind Injektoren mit Koaxialstrahl bekannt. Solche Injektoren dienen zum Auf- und Einblasen von sauerstoffreichem Gas in eine Metallschmelze mit dem Ziel, die Metallschmelze zu entkohlen und gleichzeitig eine reaktionsfähige, schützende Schaumschlackenschicht über der Metallschmelze aufzubauen. Ferner dienen solche Injektoren auch dazu, durch das gezielte Einbringen an chemischer Energie in Form brennbarer Gase den anfänglich im EAF vorhandenen Schrott aufzuschmelzen. Moderne Injektoren können zwischen diesen beiden Verfahrensmodi, d. h. zwischen dem Injektorbetrieb und dem Brennerbetrieb, umschalten. Im Folgenden wird der Begriff "Injektor" gleichbedeutend mit dem kombinierten "Brenner-Injektor" verwendet.

Der Injektor beschleunigt das sauerstoffreiche Gas, meist reinen Sauerstoff, auf Überschallgeschwindigkeit. Solche Geschwindigkeiten können ausschließlich mit einer so genannten Lavaldüse erzielt werden, die hier als Primärdüse verwendet wird.

Strömungstechnische optimierte Lavaldüsen, werden für Injektoren und Blaslanzen zum definierten Einsatz in metallurgischen Anlagen (Elektrolichtbogenofen (EAF), Reduktionsofen (SAF), Konverter (AOD, BOF), Sekundärmetallurgischen Anlage (VOD, RH) etc.) eingesetzt. Lavaldüsen bestehen aus einem konvergenten und einem divergenten Bereich, ihre Aufgabe besteht darin, den Gasstrahl (Luft, Sauerstoff, Inertgas, etc.) auf Überschallgeschwindigkeit (Machzahl $M > 1$) zu beschleunigen

Die Funktion der Lavaldüse sei am Beispiel des Einsatzes im EAF erläutert:

Seit Mitte der 1990er Jahre werden Erdgasbrenner zum Schmelzen und Überhitzen von Schrott bzw. Eisen im EAF eingesetzt, um den Bedarf an elektrischer Energie zu senken und die Produktivität zu steigern. Während die eingebrachte Energie und damit die Einschmelzleistung in der Ofenmitte am höchsten sind, bilden sich im Bereich der Ofenwände so genannte cold spots. Hier kann durch den Einbau von Brennern in die Ofenwand zusätzliche chemische Energie eingebracht werden. Des Weiteren muss die Schmelze durch das Einblasen von Sauerstoff entkohlt werden. Moderne Brennersysteme bestehen heute aus einer kombinierten Brenner-/Injektor-Technologie.

Der Injektor ist ein kombiniertes System zum Aufschmelzen von Schrott und zum Frischen der Metallschmelze. **Bild 1** zeigt den Aufbau des Injektors, bestehend aus Flammenerzeuger (flame generator) und Brenner-/Injektor-Einheit (burner/injector tube). Der Injektor besteht aus der zuvor schon beschriebenen zentralen Lavaldüse (Überschall) und einer koaxialen Ringspaltdüse (Unterschall). Der gesamte Kopf ist aus Kupfer gegossen oder geschmiedet. Lavaldüse und Ringspaltdüse werden durch innere Kanäle mit Wasser gekühlt. Der Injektor ist in einem Kupfer-Panel eingebaut, dessen Design und Anordnung einen geringen Abstand zwischen Düse und Schmelzenoberfläche zulässt. Zudem wird durch die Position der Düse die Feuerfest-Zustellung vor übermäßigem Verschleiß verschont. Infolge der Ofenwechselgefäßbauweise ist jeder Injektor auswechselbar. Zusätzlich kann das Innenleben separat ausgetauscht werden, was zur Senkung der Wartungskosten beiträgt. Alle Schläuche für die Medienversorgung sind mit Schnellkupplungen ausgerüstet. Die Durchflussmengen ($O_2$, $CH_4$, Luft) werden von einer Ventilstation gesteuert. Das Wartungsintervall des Injektors ist in der Regel länger als das des Ofengefäßes. Die Wartung erfolgt bei Gefäßwechsel oder Neuzustellung des EAF.

In der Praxis arbeitet der Injektor in unterschiedlichen Phasen, dem Pilotmodus, dem Brennermodus und dem Injektormodus, **Bild 2.**

Der Pilotmodus, **Bild 2a,** ist ein Bereitschaftsmodus und bei inaktivem Injektor vorgesehen. Die Pilotflamme besteht aus dem Verbrennungsgas des Erdgasbrenners, das mit einer Zündkerze gezündet wird. Die Flammenüberwachung erfolgt mit einer Ionisationselektrode mit Auswerteelektronik. Die Pilotflamme vermeidet, dass Schlacken- und Schmelzentropfen am Injektor anhaften. Die spezielle Düsengeometrie mit der zurückgezogenen, zentralen Primärdüse und dem konzentrisch angeordneten Ringspalt verhindert das Verstopfen der Düse durch Spritzeffekte seitens der Metallschmelze und der Schlacke.

Im Brennermodus, **Bild 2b,** wird dem EAF thermische Energie zugeführt. Sauerstoff und Erdgas werden unverbrannt durch den Injektor gefördert und vermischen sich im Ofen zu einem brennbaren Gemisch, das durch die Ofenatmosphäre zündet. Eine separate Zündung mittels Zündkerze ist nicht erforderlich. Die leistungsstarke Flamme unterstützt das Einschmelzen des Schrottes in kalten Bereichen und homogenisiert das Einschmelzbild. Anordnung und Steuerung der Brenner werden ganzheitlich betrachtet und aufeinander abgestimmt.

In der Flachbadphase wird auf den Injektormodus, **Bild 2c**, umgeschaltet. Zur schnellen Entkohlung der Metallschmelze ist die optimale Wechselwirkung von Sauerstoff und Metallschmelze ausschlaggebend. Dies wird erreicht durch einen

Überschallstrahl, der mit etwa zweifacher Schallgeschwindigkeit aus der Düse austritt und mit hohem Impuls auf die Metallschmelze trifft. Der integrierte Heißgaserzeuger (hot gas generator) liefert, ähnlich wie beim Pilotmodus, einen Hüllstrahl aus heißem Verbrennungsgas, das den kalten Sauerstoffstrahl umhüllt und dadurch die Länge des Überschallbereiches vergrößert.

Aus der WO2011/120976A1 ist bekannt, dass die - näherungsweise glockenförmige - Innenkontur einer Lavaldüse nach einem speziellen numerischen Verfahren ermittelt wird, das auf der Lösung der partiellen, gasdynamischen Differentialgleichungen beruht.

Beim Charakteristikenverfahren werden die Mach'schen Linien, d. h. die Linien schwacher Druckstörungen, die sich mit Schallgeschwindigkeit fortpflanzen und die unter einem definierten Winkel, dem Mach'schen Winkel, zum lokalen Geschwindigkeitsvektor angeordnet sind, als Grundlage für die so bezeichneten rechts- und linkslaufenden Charakteristiken angesetzt. Entlang dieser Charakteristiken ist die Lösung der partiellen Differentialgleichungen bekannt.

Das Charakteristikenverfahren löst die stationäre, isentrope, rotationssymmetrische Gasströmung mittels der räumlich diskretisierten Charakteristikengleichungen unter Berücksichtigung von Kompatibilitätsbedingungen. Mit anderen Worten wird für jede axiale Position (x-Koordinate) entlang der Primärdüse ein zugehöriger radialer Wert (r-Koordinate) so ermittelt, dass sich innerhalb der Düse eine störungsfreie Gasströmung ausbildet.

Die aus WO201120976A1 bekannte Überschalldüse beschreibt eine fest definierte Düsenklasse, die mit diesem speziell entwickelten Charakteristikenverfahren ausgelegt worden ist, mit dem Ziel,

- verschleißarme Düsen zu fertigen
- einen möglichst langen Gasstrahl, hier Sauerstoff, zu generieren.

Als Düsenklasse werden solche Düsen bezeichnet, die für einen bestimmten Druckbereich und gleichzeitig für einen bestimmten Volumenstrombereich ausgelegt worden sind. Das zuvor beschriebene Patent schützt eine spezielle, numerisch festgelegte Klasse von Einzeldüsenkonturen, welche einerseits einen reduzierten Düsenverschleiß und andererseits eine maximaler Länge des Überschallbereiches des Gasstrahls beim Einsatz in metallurgischen Aggregaten garantiert.

Aus den zuvor benannten Zusammenhängen wird ersichtlich, dass im Injektormodus, also beim Aufblasen von Sauerstoff mit einer einzelnen Primärdüse auf die Schmelzenoberfläche, es das primäre Ziel ist, die Metallschmelze möglichst effizient und effektiv zu entkohlen, aber gleichzeitig auch eine gute Schaumschlacke im EAF zu erzeugen, um die umgebende Ofengeometrie (d. h. die Kühlpanels) vor der extrem heißen Lichtbogenstrahlung abzuschirmen. Da der Sauerstoffinjektor in einem vorgelagerten EAF-Panel eingebaut wird, und unter einem Winkel von ca. 40° - 45° angeordnet ist, muss der Sauerstoffstrahl unter Umständen lange Wegstrecken von bis zu 3 m überbrücken, um zur Schmelzenoberfläche zu gelangen. Dies geschieht insbesondere in der Flachbadphase. Daher wird es erforderlich, einen möglichst langen, kohärenten Sauerstoff-Überschallstrahl zu generieren, der mit einem hohen Strahlimpulsstrom bzw. Strahlkraft (in Newton) auf die Schmelzenoberfläche trifft. Nur in diesem Fall ist eine gute Entkohlung bei gleichzeitig intensiver Vermischung der Metallschmelze möglich. Damit die Überschalllänge möglichst lang ist, darf der Gasstrahl keinerlei Störungen, weder innerhalb noch außerhalb der Lavaldüse, aufweisen, was bei schlecht ausgelegter Wandkontur sowohl der Lavaldüse als auch der Ringspaltdüse der Fall sein kann.

Darstellung der Erfindung

Ausgehend vom Stand der Technik ist es eine Aufgabe der vorliegenden Erfindung, einen Injektor anzugeben, der eine weiter verbesserte Überschalllänge bereitstellt.

Diese Aufgabe wird durch einen Injektor mit den Merkmalen des Anspruchs 1 gelöst. Vorteilhafte Weiterbildungen ergeben sich aus den Unteransprüchen.

Entsprechend wird ein Injektor zum Einsatz in metallurgischen Anlagen, insbesondere in einem Basic Oxygen Furnace (BOF), in einem Argon Oxygen Decarburization (AOD) Konverter oder in einem Elektrolichtbogenofen (EAF), vorgeschlagen mit einer als Überschalldüse ausgelegten Primärdüse zum Aufblasen eines sauerstoffreichen Gases auf eine Metallschmelze und einer koaxial zur Primärdüse angeordneten Sekundärdüse zum Erzeugen eines den aus der Primärdüse austretenden Gasstrahl umgebenden Koaxialstrahls, wobei die Primärdüse einen konvergenten Abschnitt und einen divergenten Abschnitt aufweist, welche in einem Radius des engsten Querschnitts r* aneinander angrenzen, dadurch gekennzeichnet, dass die Primärdüse und die Sekundärdüse durch folgende Schar von Düsenformen in deren jeweiligem Auslegungsfall definiert sind:

| Primärdüse | | | | | Sekundärdüse | | |
|---|---|---|---|---|---|---|---|
| Druck $p_0$ [bar] | Volumenstrom $V_0$ [Nm$^3$/min] | Radius im engsten Querschnitt r* [mm] | Austrittsradius $r_1$ [mm] | Düsenlänge l [mm] | Machzahl $M_s$ [-] | Temperatur $T_s$ [K] | Koaxialspalthöhe $H_s$ [mm] |
| 4 | 20 | 12.0 | 14.0 | 50 ± 20 | 0.5 ± 0.2 | 1000 ± 200 | 7±3 |
| 4 | 200 | 39 | 44.0 | 160 ± 20 | 0.5 ± 0.2 | 1000 ± 200 | 7±3 |
| 14 | 20 | 6 | 10.0 | 50 ± 20 | 0.5 ± 0.2 | 1000 ± 200 | 7±3 |
| 14 | 200 | 21 | 33.0 | 160 ± 20 | 0.5 ± 0.2 | 1000 ± 200 | 7±3 |

Die oben gestellte Aufgabe wird weiterhin durch einen Injektor mit den Merkmalen des Anspruchs 2 gelöst. Vorteilhafte Weiterbildungen ergeben sich aus den Unteransprüchen.

Entsprechend wird ein Injektor zum Einsatz in metallurgischen Anlagen, insbesondere in einem Basic Oxygen Furnace (BOF), in einem Argon Oxygen Decarburization (AOD) Konverter oder in einem Elektrolichtbogenofen (EAF), vorgeschlagen mit einer als Überschalldüse ausgelegten Primärdüse zum Aufblasen eines sauerstoffreichen Gases auf eine Metallschmelze und einer koaxial zur Primärdüse angeordneten Sekundärdüse zum Erzeugen eines den aus der Primärdüse austretenden Gasstrahl umgebenden Koaxialstrahls, wobei die Primärdüse einen konvergenten Abschnitt und einen divergenten Abschnitt aufweist, welche in einem Radius des engsten Querschnitts r* aneinander angrenzen, dadurch gekennzeichnet, dass die Innenkontur und die Außenkontur der Sekundärdüse numerisch so bestimmt wird, dass die konvektive Machzahl $M_{c\infty s}$ zwischen der Umgebung ($\infty$) und dem durch die Sekundärdüse erzeugten Sekundärstrahl (s) gleich ist mit der konvektiven Machzahl $M_{csp}$ zwischen dem Sekundärstrahl (s) und dem durch die Primärdüse erzeugten Primärstrahl (p):

$$M_{c\infty s} = M_{csp}$$

Die oben genannten Lösungen haben den Vorteil, dass gegenüber einer Einzeldüse ohne Sekundärstrahl die Überschalllänge des zentralen Sauerstoffstrahls, also des Primärstrahls, durch den parallelen, angepassten Sekundärstrahl um bis zu ca . 40 % vergrößert wird. Weiterhin zeigt für den Auslegungsfall der Sauerstoffstrahl innerhalb und außerhalb der Primärdüse keine oder wenn, dann nur sehr geringe Druckstörungen. Der Gasstrahl liegt damit sauber an der Düsenkontur an und kühlt die Wandung. Der Düsenverschleiß ist damit gering.

Aufgrund des längeren zentralen Sauerstoffstrahls ist mit einer besseren metallurgischen Arbeit zu rechnen, was die Produktivität erhöht und Kosten senkt.

Weiterhin kann wegen des längeren zentralen Sauerstoffstrahls der Injektor gegenüber Injektoren mit kürzerem Sauerstoffstrahl bei gleicher metallurgischen Arbeit höher über dem Metallschmelzenlevel positioniert werden. Der Injektor ist dort besser vor Metall-/Schlackenspritzern geschützt.

Weiterhin kann bei Öfen mit großem Durchmesser der Injektor auch entfernt liegende Schmelzenregionen erreichen.

Bevorzugt sind die Primärdüse zur Verwendung mit Sauerstoff und die Sekundärdüse zur Verwendung mit $CH_4$ oder LPG bestimmt.

Weiterhin bevorzugt ist es, wenn die Sekundärdüse als Unterschalldüse ausgelegt ist.

In einer bevorzugten Ausgestaltung ist ein mit der Sekundärdüse gekoppelter Heißgaserzeuger vorgesehen, welcher über die Sekundärdüse einen Sekundärstrahl an heißem Verbrennungsgas bereitstellt. Besonders bevorzugt ist der Heizgaserzeuger so steuerbar, dass die für die Auslegung der Sekundärdüse und der Primärdüse optimierte Menge an Abgas bei einer optimierten Abgastemperatur erreicht wird.

In einer weiteren bevorzugten Weiterbildung entspricht die Innenkontur der Primärdüse der auf numerischem Wege mit einem modifizierten Charakteristikenverfahren ermittelten Kontur.

Hierbei wird die Innenkontur der Primärdüse durch die numerische Lösung der partiellen gasdynamischen Differentialgleichungen ermittelt, bei welchen die stationäre, isentrope, rotationssymmetrische Gasströmung mittels räumlich diskretisierten Charakteristikengleichungen unter Berücksichtigung entsprechender Kompatibilitätsbedingungen dargestellt ist. Besonders bevorzugt wird bei der Lösung der partiellen numerischen Differentialgleichungen der Einfluss einer reibungsbehafteten, wandnahen Grenzschichtströmung berücksichtigt.

Weiterhin bevorzugt weist bei der Primärdüse das Verhältnis der Düsenlänge I zum Radius im engsten Querschnitt $r^*$, also $I/r^*$, zwischen 2,1 und 11,6, bevorzugt zwischen 2,1 und 8,3, noch bevorzugter zwischen 2,1 und 5,4, noch bevorzugter zwischen 2,1 und 5,0 liegt, und insbesondere Werte von 11,6, 8,3, 5,4, 5,0, 4,8, 4,2, 4,1, 3,6, 3,3, 3,1 oder 2,1 auf.

Weitere bevorzugte Ausführungsbeispiele ergeben sich aus den Unteransprüchen oder Anspruch 15.

Kurze Beschreibung der Zeichnungen

Nachfolgend wird die vorliegende Offenbarung auf Grundlage der beigefügten Figuren noch einmal ausführlich erläutert. In den Figuren zeigen:

Bild 1 zeigt den Aufbau eines Injektors nach dem Stand der Technik

Bilder 2a - c zeigen den Injektor in unterschiedlichen Betriebsphasen.

Bilder 3a und 3b zeigen die stömungstechnischen Bedingungen

Bild 4 zeigt eine typische Düsenkontur für einen entsprechend ausgelegten Injektor

Bild 5 zeigt die gewählten Bezeichnungen in dem Injektor

Bild 6 zeigt eine erfindungsgemäß ausgelegte Injektorgeometrie

Detaillierte Beschreibung der Zeichnungen

Nachfolgend werden unterschiedliche Ausführungsformen der vorliegenden Offenbarung beschrieben, wobei gleiche Bezugszeichen für gleiche oder ähnliche Komponenten verwendet werden und teilweise auf die wiederholte Beschreibung verzichtet wird.

Die Bilder 1 und 2 waren bereits zum Stand der Technik diskutiert worden.

Bild 1 zeigt ein Beispiel eines kombinierten Brenner-Injektors zum Einsatz im Elektrolichtbogenofen mit zurückgezogener Primärdüse mit umgebender Koaxialdüse.

Die Bilder 2a, 2b und 2 c zeigen das Funktionsprinzip eines kombinierten Brenner-Injektors zum Einsatz im Elektrolichtbogenofen.

Bild 2a zeigt den Pilotmodus zum Freihalten der Düsen vor Metallschmelzen-/Schlackespritzern.

Bild 2b zeigt den Brennermodus zum unterstützenden Einschmelzen von Schrott.

Bild 2c zeigt den Injektormodus zur Entkohlung und Schaumschlackebildung

**Bild 3a** zeigt die strömungstechnischen Bedingungen und die gewählte Notation für einen Überschallstrahl, der aus einer Einzeldüse in Form eines Primärstrahls austritt. Diese Primärdüse besteht aus einem konvergenten Einström- und einem divergenten Ausströmbereich. Im Unterschallteil wird der Sauerstoff beschleunigt, erreicht im engsten Querschnitt, den Düsenhals (throat) erstmals Schallgeschwindigkeit (M = 1) und beschleunigt infolge der Expansion im divergenten Teil weiter. Dabei kühlt sich der Sauerstoff bis auf ca. -110°C ab, bevor er in die heiße Ofenumgebung eintritt und sich dort mit dem heißen Umgebungsgas vermischt. Typischerweise tritt der Sauerstoff mit zweifacher Schallgeschwindigkeit (M = 2) aus der Düse aus. Die Machzahl ist das Verhältnis aus lokaler Gasgeschwindigkeit u und Schallgeschwindigkeit a $\left( M = u/a \ \text{mit} \ a = \sqrt{\gamma RT} \right)$. Hierin ist y der Isentropenexponent, R die spezifische Gaskonstante und T die Temperatur des Sauerstoffs.

Zur Kennzeichnung der Bereiche in Bild 3 werden die thermodynamischen Zustandsgrößen (Druck p, Temperatur T) im Düseneintritt mit dem Index (0), im Düsenhals mit (*) und im Austritt mit (1) bezeichnet. Stromabwärts der Düse befindet sich heißes Ofengas ($\infty$) mit typischen Temperaturen von 1650°C. Die wesentlichen Auslegungsgrößen für die einzelne Primärdüse sind der Eintrittdruck $p_{0,ox}$, der Sauerstoff-Volumenstrom $\dot{V}_{0,ox}$ und der Umgebungsdruck $p_{\infty}$.

Als Näherungsformel gilt für einen *kalten* Sauerstoffstrahl, der in eine *kalte* Umgebung mit ca. 20°C eintritt, dass die Länge des Überschallbereiches ca. das 10- bis 20-fache des Düsenaustrittsdurchmessers beträgt $\left( L_p^* / d_1 \approx 10 \ \text{bis} \ 20 \right)$, vgl. Bild 3a.

Dahingegen gilt für einen *kalten* Sauerstoffstrahl, der in eine *heiße* Umgebung mit ca. 1650°C eintritt, dass die Länge des Überschallbereiches ca. das 20- bis 30-fache des Düsenaustrittsdurchmessers beträgt $\left( L_p^* / d_1 \approx 20 \ \text{bis} \ 30 \right)$.

Nun kann aber selbst mit einer strömungstechnisch optimierten Primärdüse nur eine ganz bestimmte Überschalllänge $L_p^*$ erzielt werden. Aufgabe des Injektors mit Koaxialstrahl und Verfahren zu dessen Auslegung und Betrieb ist es, diese Überschalllänge $L_p^*$ durch einen mathematisch beschriebenen, zusätzlichen Hüllstrahl, im weiteren Verlauf auch Koaxialstrahl genannt, deutlich zu verlängern.

Aus der Literatur, siehe "Murakami E.; Papamoschou, D.: Mean flow development in dual-stream compressible jets, The American Institute of Aeronautics and Astronautics (AIAA) 40 (2002) 6, p. 1131-1138", ist bekannt, das ein den Primärstrahl (Index p - primary) umgebender Koaxialstrahl (Index s - secondary) die Länge des zentralen Überschallstrahls vergrößert. Dieser Koaxialstrahl wird in einer ringförmigen Düse erzeugt, die um die zentrale Primärdüse angeordnet ist. Dieses physikalische Phänomen wird im vorliegenden Fall auf den Injektor übertragen, jedoch mit einem völlig neu entwickelten Modellansatz. Während das Modell nach *Murakami und Papamoschou (2002)* davon ausgeht, dass beide Strahlen, d. h. Primärstrahl und Koaxialstrahl (Hüllstrahl) kalt sind und in eine kalte Umgebung eintreten, wird im vorliegenden, neuen Modell ein mathematischer Ansatz verwendet, bei dem

- der Primärstrahl kalt ist,

- der Sekundärstrahl (gleichbedeutend Koaxialstrahl, Hüllstrahl) heiß is und
- beide Strahlen, d. h. Primärstrahl und Sekundärstrahl, parallel und mit geringst möglichem Abstand zueinander in eine heiße Umgebung bei rd. 1650°C eintreten.

Damit kann der neue mathematische Modellansatz beispielsweise auf die Randbedingungen eines EAF angewendet werden. Das neue Modell, dass im Folgenden mit Koaxialstrahlmodell bezeichnet wird, wurde durch detaillierte numerische Simulationen mit Hilfe der DNS (Direct Numerical Simulation) validiert.

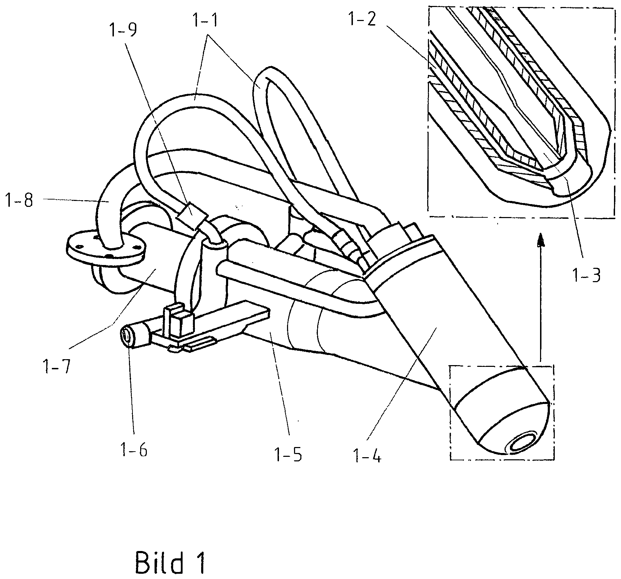

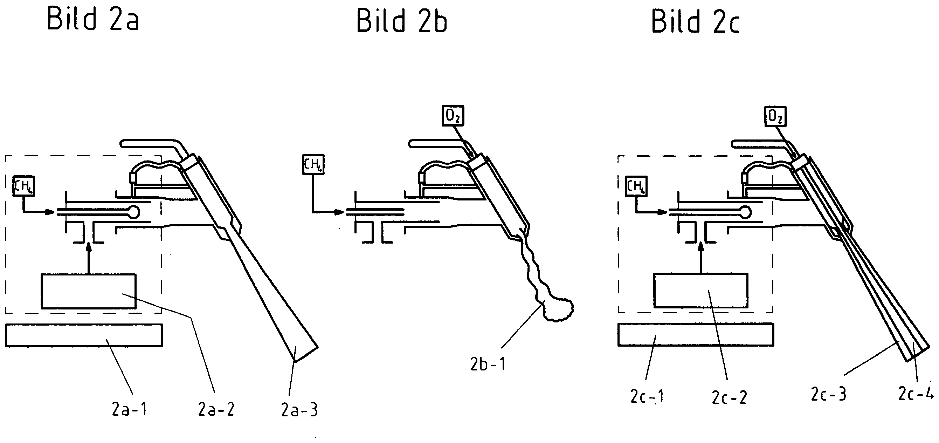

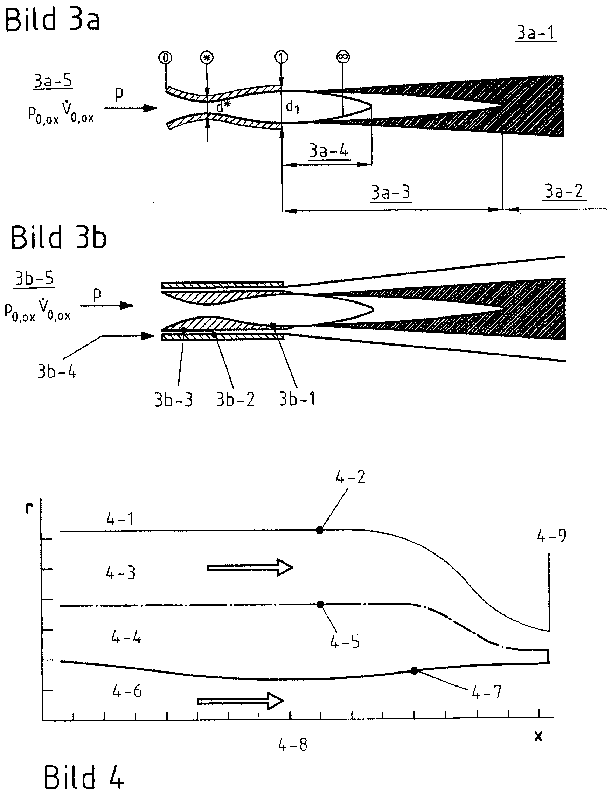

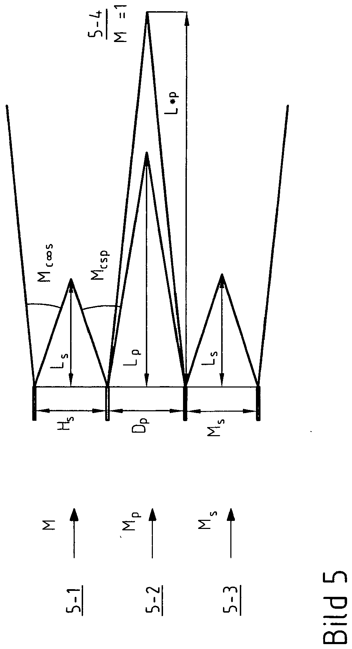

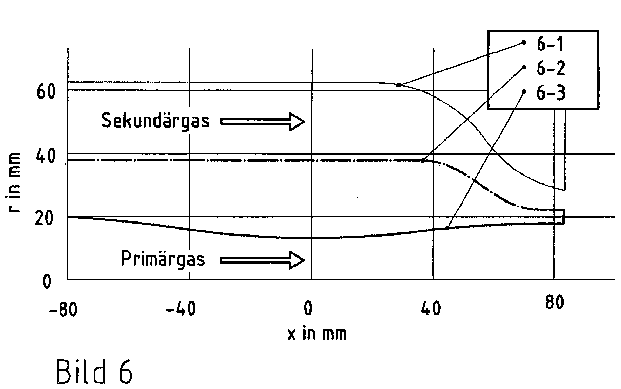

Die in Figur 3b gezeigte Koaxialdüse besteht aus einer zentralen Primärdüse (Überschall: M>1) und einer rotationssymmetrischen Düse (Unterschall M<1), der eigentlichen Koaxialdüse. Durch die Primärdüse fließt das kalte Primärgas (p), maßgeblich Sauerstoff, durch die Koaxialdüse heißes Verbrennungsgas, maßgeblich $CO_2$.

Um den zentralen, kalten Sauerstoff-Überschallstrahl (Primärstrahl - p) wird ein ringförmiger, heißer Unterschall-Hüllstrahl bzw. Unterschall-Koaxialstrahl (Sekundärstrahl - s) aus bereits verbranntem Abgas mit hoher Geschwindigkeit parallel zum Primärstrahl injiziert, um den Primärstrahl vor der heißen Ofenatmosphäre zu schützen und die Scherschicht-Interaktionen zwischen Primärstrahl und heißer Ofenumgebung zu minimieren. Dieses Vorgehen ist in **Bild 3b** veranschaulicht.

Durch diese Maßnahme kann die Länge des Primärstrahls vergrößert werden. Hierbei ist das korrekte und hier erstmals mathematisch beschriebene Zusammenwirken zwischen Primärstrahl und Sekundärstrahl sehr entscheidend. Dieses Zusammenwirken wird durch folgende Parameter am Austritt der Sekundärdüse beschrieben bzw. beeinflusst:

- Machzahl $M_s$ des Koaxialstrahls (und damit die Austrittsgeschwindigkeit)
- Temperatur $T_s$ des Koaxialstrahls
- Verhältnis $H_s/D_1$ der Koaxialspalthöhe $H_s$ zum Austrittsdurchmesser der Primärdüse $D_1$

In einem mathematisch-numerischen Verfahren (DNS) wurden diese drei Parameter so bestimmt, dass beide Strahlen, d. h. Primärstrahl und Koaxialstrahl, exakt aufeinander abgestimmt sind und eine maximale Überschalllänge $\overset{*}{L_p}$ des kalten Primärstrahls gebildet wird. Die Überschalllänge $\overset{*}{L_p}$ der neuen Koaxialdüse ist um rd. 40 % größer als die einer Einzeldüse ohne Hüllstrahl. Hauptkriterium für das exakte Zusammenwirken von Primär- und Sekundärstrahl ist, dass die konvektive Machzahl $M_{c\infty S}$ zwischen Umgebung ($\infty$) und Sekundärstrahl (s) gleich sein muss mit der konvektiven Machzahl $M_{csp}$ zwischen Sekundärstrahl (s) und Primärstrahl (p). Dies ist ein völlig neuer mathematischer Ansatz für die Auslegung von Koaxialstrahlen, die in eine heiße Umgebung eintreten. Bisherige mathematische Ansätze sind davon ausgegangen, dass die Geschwindigkeiten von Primär- und Sekundärstrahl gleich sein müssen.

Damit wird für einen Injektor, vorzugsweise einen Sauerstoffinjektor, die physikalisch maximal mögliche Länge $\overset{*}{L_p}$ des Überschallbereiches erweitert. Zu diesem Zweck wird ein sekundärer Hüllstrahl (Koaxialstrahl) um den Primärstrahl gelegt, welcher den Primärstrahl vor dem umgebenden Ofengas (CO, $CO_2$, Luft, etc.) abkapselt und schützt. Es wurde ein völlig neues mathematisches Hüllstrahlmodell (Koaxialstrahlmodell) entwickelt, das zur Injektorauslegung verwendet wird. Eine spezielle Klasse von Injektoren, die mit diesem Koaxialstrahlmodell ausgelegt wurden, wird geschützt.

Die Anwendung bezieht sich in erster Linie auf Injektoren, hier auch kombinierte Brenner-Injektoren, für den Sauerstoffeintrag im EAF. Grundsätzlich ist die Methode aber auf jeden Injektor mit Hüllstrahl übertragbar.

Die Anwendung des Koaxialstrahlmodells beruht auf der bereits optimalen Auslegung der zentralen Primärdüse. Im ersten Schritt wird die glockenförmige Kontur der Primärdüse, d. h. rotationssymmetrisch auf Basis eines rein numerischen Verfahrens, das auf einem modifizierten Charakteristikenverfahren aufbaut, ermittelt. Durch die glockenförmige Kontur ist gewährleistet, dass die Primärdüse störungsfrei und verschleißarm arbeitet, der Strahlimpulsstrom bzw. die Kraft am Düsenaustritt maximal ist und bereits auf diese Weise eine relativ große Überschalllänge des Sauerstoffstrahls realisiert wird.

Im zweiten Schritt erfolgt dann die Auslegung der Sekundärdüse (Koaxialdüse). Berechnet werden Innen- und Außenkontur der Sekundärdüse sowie die erforderlichen Mengen an Brenngas ($CH_4$, LPG, etc.), Luft und/oder Sauerstoff, welche zur Koaxialdüse zugegeben, innerhalb des Injektors gezündet und verbrannt werden müssen. Das heiße Verbrennungsgas tritt mit Temperaturen zwischen rd. 500°C und 1000°C aus der Sekundärdüse aus. Die Auslegungsprozedur beruht darauf, dass alle Größen so aufeinander abgestimmt sind, dass sich die maximal mögliche Überschalllänge $\overset{*}{L_p}$ des Primärstrahls ausbildet.

Gemäß dem ersten Schritt wird die optimale, glockenförmige, rotationssymmetrische Form der Primärdüse auf der Basis eines rein numerischen Verfahrens, das auf einem modifizierten Charakteristikenverfahren aufbaut, ermittelt. Diese Methode berücksichtigt sowohl den Reibungseinfluss in der Strömungsgrenzschicht als auch die Verdrängungswirkung der Strömungsgrenzschicht auf die Kernströmung. Mehrdimensionale Strömungseffekte werden also berücksichtigt. Durch die glockenförmige Kontur ist gewährleistet, dass die Überschalldüse störungsfrei und verschleißarm arbeitet, der Strahlimpuls am Düsenaustritt maximal ist und eine sehr lange Überschalllänge des Gasstrahls realisiert wird. Ein weiterer, wesentlicher Vorteil ist, dass die Düsenlänge bei verbesserter Effizienz noch um ca. 20 - 30 % reduziert werden und Kupfermaterial gespart werden kann. Das Gewicht der Blaslanze beziehungsweise des Injektors wird deutlich reduziert, was den Einbau des Aggregates vereinfacht.

Zu diesem Zweck wird die ideale Wandkontur der Überschalldüse für das jeweilige metallurgische Aggregat mit einem speziellen, modifizierten Charakteristikenverfahren auf rein numerischem Wege ermittelt. Die Charakteristikenmethode ist ein Verfahren zur Lösung der partiellen, gasdynamischen Differentialgleichungen. Dabei werden die Mach'schen Linien, d.h. die Linien schwacher Druckstörungen, die sich mit Schallgeschwindigkeit fortpflanzen und die unter einem definierten Winkel zum lokalen Geschwindigkeitsvektor angeordnet sind, als Grundlage für die so genannten rechts- und linkslaufenden Charakteristiken angesetzt. Entlang dieser Charakteristiken ist die Lösung der partiellen Differentialgleichungen bekannt. Das Charakteristikenverfahren wird im vorliegenden Fall mit einer Grenzschichtkorrektur gekoppelt, wodurch der impulsvermindernde Einfluss der Strömungsgrenzschicht in der Primärdüse berücksichtigt wird. Mit Hilfe dieses rein numerischen Verfahrens wird eine Klasse von Düsenkonturen entworfen die zum Einsatz in metallurgischen Anlagen gut geeignet sind.

Die typische Kontur einer Überschalldüse besteht aus einem konvergenten Unterschallteil (subsonic part) und einem divergenten Überschallteil (supersonic part). Häufig bezeichnet man den Überschallteil auch als Expansionsteil.

Innerhalb der Grenzschicht wird das Gas von der maximalen Geschwindigkeit am Grenzschichtrand bis auf die Geschwindigkeit Null an der Wand abgebremst. Direkt an der Wand gilt die so genannte Haftbedingung (no-slip-condition). Die einzelnen Bereich der Düsenströmung (M < 1, M = 1, M > 1) sind in der Figur eingezeichnet.

Der mathematische Weg des gesamten Verfahrens ist komplex und wird daher hier nur ansatzweise beschrieben. Die Lösung basiert u.a. auf folgenden Gleichungen:

a) Grundgleichung der stationären, isentropen, rotationssymmetrischen Gasströmung.

$$(u^2 - a^2)\frac{\partial u}{\partial x} + (v^2 - a^2)\frac{\partial v}{\partial r} + uv(\frac{\partial u}{\partial r} + \frac{\partial v}{\partial x}) = a^2 \frac{v}{r}$$

u,v: Strömungsgeschwindigkeit in Axial- und Radialrichtung
x,r: Axial- und Radialkoordinate
a: Schallgeschwindigkeit

b) Numerische Lösung der Charakteristikengleichungen und der Kompatibilitätsbedingungen entlang der Charakteristiken.
Charakteristikengleichungen:

$$\left(\frac{dr}{dx}\right)c^- = \tan(\theta - \alpha) \qquad \text{und} \qquad \left(\frac{dr}{dx}\right)c^+ = \tan(\theta + \alpha)$$

c-, c+: rechtslaufende und linkslaufende Charakteristiken
$\theta$: Winkel zwischen dem lokalen Geschwindigkeitsvektor und dem Koordinatensystem; Strömungswinkel
$\alpha$: Mach'scher Winkel

Kompatibilitätsbedingungen entlang der Charakteristiken:

$$d(\theta + v)_{c-} = \frac{1}{\sqrt{M^2 - 1} - \cot\theta}\frac{dr}{r} \qquad \text{und} \qquad d(\theta - v)_{c+} = -\frac{1}{\sqrt{M^2 - 1} + \cot\theta}\frac{dr}{r}$$

M: Machzahl
c) Schalllinie und Initiallinie im Düsenhals werden mit den Störpotentialgleichungen für rotationssymmetrische kompressible Strömungen ermittelt.

$$(\gamma + 1)\varphi'x\varphi''xx - \varphi'rr - \frac{\varphi'r}{r} = 0$$

$\varphi$: Störpotential

$\gamma$: Isentropen-Koeffizient

d) Die Strömungsgeschwindigkeiten werden mit der kritischen Schallgeschwindigkeit a* berechnet, d. h. $u' = \varphi'_x$ und $v' = \varphi'_r$.

$$u'(x,r) = kx + \frac{(\gamma + 1)k^2 r^2}{4} \qquad \text{und} \qquad v(x,r) = \frac{(\gamma + 1)k^2 xr}{2} + \frac{(\gamma + 1)^2 k^3 r^3}{16}$$

k: Konstante

Die Initialwerte werden von der Initiallinie bis zur Initial-Charakteristik berechnet. Hierbei wird ein spezielles Iterationsverfahren zur Bestimmung der Gitterpunkte und der zugehörigen Strömungsparameter sowie zur Berücksichtigung der Krümmung der Charakteristiken eingesetzt.

e) Der Expansionsteil der Überschalldüse mit *positiver Konturkrümmung* wird von der Initialcharakteristik bis zur letzten Expansionscharakteristik berechnet. Hierbei wird eine spezielle Kontur-Funktion angesetzt der Form:

$$r = a + bx + cx^2 \qquad \text{und} \qquad \frac{dr}{dx} = \tan\theta = b + 2cx$$

a,b,c: Konstanten

Letztlich werden die Strömungsgrößen auf der Basis der Charakteristiken und der Kontur-Funktion ermittelt. Die Auslegungs-Machzahl auf der Strahlachse wird dabei kontrolliert.

f) Der Expansionsteil der Überschalldüse mit *negativer Konturkrümmung* wird durch die letzte Expansionscharakteristik und die Mach'sche Linie vom Achsenpunkt festgelegt. Basis sind die so genannten Backward-Charakteristiken c⁻ und die Wandstromlinie.

g) Für gegebene Werte von $r_k$, $R_1$, $R_2$ und $\beta$ wird der Unterschallteil der Überschalldüse durch spezielle Konturfunktionen in Form von Kreisbögen festgelegt, siehe Figur 4.

$$r = f(x_k, r_k, R_2) \text{ für } x \leq x_2$$

$$r = f(x_1, x_2, r_1, r_2) \text{ für } x_2 \leq x \leq x_1$$

$$r = f(x_t, r_t, R_1, R_2) \qquad \text{für } x_1 \leq x \leq x_t$$

Als Ergebnis der iterativen Rechnung erhält man eine optimierte, glockenförmige Düsenkontur.

Im zweiten Schritt wird, ausgehend von der entsprechend optimierten, glockenförmigen Düsenkontur, die Geometrie der Sekundärdüse bestimmt.

Der Strahl der Sekundärdüse, der auch als Koaxialstrahl, Hüllstrahl oder Ringstrahl bezeichnet wird, schützt den innen liegenden, zentralen Überschallstrahl der Primärdüse, da die Interaktionen in den rotationssymmetrischen Scherschichten verringert und der Primärstrahl dadurch stabiler wird.

Der zu Grunde liegende physikalische Mechanismus besteht darin, die Dichte des Sekundärstrahls soweit wie möglich gegenüber der Dichte des Primärstrahls abzusenken. Dies wird erreicht, indem auf der Sekundärseite ein heißes Abgas niedriger Dichte verwendet wird. Die Anpassung der Dichte über Temperatur alleine ist jedoch nicht zielführend, da bei falscher Auslegung die gasförmigen Scherschichten (Primärstrahl - Sekundärstrahl - Umgebung) instabil werden, sich aufrollen und dadurch die effektive Strahllänge verkürzen.

Der wichtigste Aspekt bei der Auslegung der Injektoren mit Koaxialstrahl besteht darin, dass nicht die Austrittsgeschwindigkeiten zwischen Primär- und Sekundärdüse gleich sein müssen, sondern die entsprechenden konvektiven Machzahlen. Die konvektive Machzahl $M_c$ beschreibt das Verhältnis aus der Strömungsgeschwindigkeit u der großräumigen Wirbel, die konvektiv stromabwärts transportiert werden, zur lokalen Schallgeschwindigkeit a.

Eine Vielzahl von DNS-Simulationen hat gezeigt, dass für die bereits genannten Größen

- Machzahl $M_s$ des Koaxialstrahls

- Temperatur $T_s$ des Koaxialstrahls
- Verhältnis $H_s/D_1$ der Koaxialspalthöhe $H_s$ zum Austrittsdurchmesser der Primärdüse $D_1$

ein Optimum existiert, bei dem sich die maximale Länge $\overset{*}{L_p}$ des Primärstrahls einstellt. Das neue Optimierungs-Kriterium besagt, dass die konvektive Machzahl $M_{c\infty S}$ zwischen Umgebung ($\infty$) und Sekundärstrahl (s) gleich sein muss mit der konvektiven Machzahl $M_{csp}$ zwischen Sekundärstrahl (s) und Primärstrahl (p):

$$\text{Zentrales Optimierungskriterium:} \quad M_{c\infty s} = M_{csp}$$

Die berechnete Düsenkontur eines nach dem neuen Verfahren ausgelegten Injektors ist in **Bild 4** dargestellt. Die innere Primärdüse (Primärdüse, kalter Sauerstoff) besteht aus dem konvergenten Unterschallteil und dem divergenten Überschallteil mit zunächst positiver und im weiteren x-Verlauf negativer Krümmung.

Ausgangspunkt des neuen Verfahrens ist die Innenkontur dieser Primärdüse, die mit dem Charakteristikenverfahren ausgelegt wurde. Die Innenkontur ist die optimale Kontur, um einen langen Überschallbereich $\overset{*}{L_p}$ zu erzeugen.

Darauf aufsetzend bestimmt das neue Verfahren numerisch die Innenkontur und die Außenkontur der äußeren Sekundärdüse (Koaxialdüse, heißes Abgas) und zwar in der Form, dass sowohl die gesamte Geometrie als auch die thermischen Prozessgrößen des Koaxialgases so berechnet werden, dass die Überschalllänge $\overset{*}{L_p}$ des Primärstrahls nochmals verlängert wird.

In Bild 5 sind folgende Bezeichnungen für das neue Koaxialstrahlmodell gewählt:

Kalter Primärstrahl (p) z. B. Sauerstoff, umgeben von einem rotationssymmetrischen Ringspalt mit heißem Sekundärstrahl (s), z. B. Verbrennungsgas, beim Eintritt in eine heiße Ofenumgebung.

Der mathematische Weg des numerischen Verfahrens ist komplex und wird hier nur ansatzweise beschrieben, zur Veranschaulichung dient **Bild 5.** Die Lösung basiert u. a. auf folgenden Gleichungen:

a) Bestimmung der konvektiven Machzahlen:

Einzelstrahl (Single-Jet): $M_{c\infty p}$ zwischen Umgebung und Primärstrahl

$$M_{c\infty p} = \frac{M_p \sqrt{\rho_\infty / \rho_p}}{(1 + \sqrt{\rho_\infty / \rho_p})(\gamma_\infty / \gamma_p)^{1/4}}$$

Koaxialstrahl: $M_{c\infty s}$ zwischen Umgebung und Sekundärstrahl sowie $M_{csp}$ zwischen Sekundärstrahl und Primärstrahl

$$M_{c\infty s} = \frac{M_s \sqrt{\rho_\infty / \rho_s}}{(1 + \sqrt{\rho_\infty / \rho_s})(\gamma_\infty / \gamma_s)^{1/4}} \quad, \qquad M_{csp} = \frac{M_p \sqrt{\rho_s / \rho_p}(1 - u_s / u_p)}{(1 + \sqrt{\rho_s / \rho_p})(\gamma_s / \gamma_p)^{1/4}}$$

$\rho, u, \gamma$ : Dichte, Strömungsgeschwindigkeit und Isentropenexponent
$\infty, s, p$ : Umgebung, Sekundär- und Primärstrahl
M: Machzahl der Strömung

b) Bestimmung des optimalen Betriebsparameters für den Koaxialstrahl, gültig für kalten Primärstrahl, heißen Sekundärstrahl und heiße Umgebung.

$$\text{Neues Optimierungs-Kriterium:} \quad M_{c\infty s} = M_{csp}$$

Machzahl des Sekundärstrahls:

$$M_s = \frac{u_s}{a_s} = \frac{u_p}{a_s}\left[1 + \frac{a_p}{a_s}\left(\frac{1+\sqrt{\rho_p/\rho_s}}{1+\sqrt{\rho_s/\rho_\infty}}\right)\left(\frac{\gamma_p\gamma_\infty}{\gamma_s^2}\right)^{-1/4}\right]^{-1}$$

Beispielsweise Vereinfachung für y = const:

$$M_{c\infty s} = \frac{u_s}{a_s + a_\infty} = M_{csp} = \frac{u_p - u_s}{a_p + a_s}\,, \qquad\qquad M_s = \frac{u_s}{a_s} = \frac{u_p(a_s + a_\infty)}{a_s(a_p + 2a_s + a_\infty)}$$

c) Bestimmung des neuen Korrelationsmodells für den Koaxialstrahl, gültig für kalten Primärstrahl, heißen Sekundärstrahl und heiße Umgebung.

Funktionen der konvektiven Machzahl:

$$F_{\infty p} = M_{c\infty p}^2\,, \qquad F_{sp} = M_{csp}^2\,, \qquad F_{\infty s} = M_{c\infty s}^2\,,$$

Schalter- und Geometrie-Funktionen:

$$F_{\infty sp} = \alpha\left(\frac{F_{sp}F_{\infty s}}{\beta F_{sp} + F_{\infty s}}\right)\,, \qquad F_p = 1 + \frac{F_{\infty sp}}{F_{sp}F_{\infty p}}\left(F_{sp} - F_{\infty p}\right)\,, \qquad F_h = 1 + \sigma\left(H_s/D_p\right)\,,$$

Funktion der Strahllänge:

$$\frac{L_p^*}{L_{single}^*} = \varphi F_h \cdot \exp\left[-\theta \cdot \text{abs}\left(F_p\right)\right]$$

$\alpha, \beta, \sigma, \varphi, \theta$ : Konstanten, müssen so bestimmt werden, das $L_p^*$ maximal ist $L_{single}^*$ : Überschallstrahllänge für Einzelstrahl

$L_p^*$ : Überschallstrahllänge für Koaxialstrahl

d) Injektormodus:

Zur Erzeugung des heißen Hüllgases wird Brennstoff ($CH_4$, LPG, etc.) mit Luft vermischt und innerhalb des Injektors intern verbrannt. Das heiße, verbrannte Abgas bildet den heißen Hüllstrahl. Der Algorithmus berechnet in Abhängigkeit der Brennstoffart die notwendige Menge an Brennstoff und Luft, um a) die optimale Menge an Abgas bei b) optimaler Abgastemperatur zu erzielen.

Stöchiometrischer Koeffizient: $\lambda = \dfrac{\dot{m}_{air}}{\dot{m}_{air,st}}$

$\dot{m}_{air}$ : Massenstrom der Luft
$\dot{m}_{air,st}$ : Massenstrom der Luft bei stöchiometrischer Verbrennung

Beispiel: Brennstoff $CH_4$
Massenbilanz:

$$CH_4 + \tilde{m}_{O2}\lambda O_2 + \tilde{m}_{N2}\lambda N_2 \rightarrow \tilde{m}_{CO2}CO_2 + \tilde{m}_{H2O}H_2O + \tilde{m}_{O2}(\lambda - 1)O_2 + \tilde{m}_{N2}\lambda N_2$$

m: Molmassen-Verhältnis der Komponente
Energiebilanz:

$$-\dot{Q}_v/\dot{m}_{CH4} = \tilde{m}_{CO2}c_{p,CO2}\Big|_{T0}^{Ts}(T_s - T_0) + \tilde{m}_{H2O}c_{p,H2O}\Big|_{T0}^{Ts}(T_s - T_0)$$

$$+ \tilde{m}_{O2}(\lambda - 1)c_{p,O2}\Big|_{T0}^{Ts}(T_s - T_0) + \tilde{m}_{N2}\lambda c_{p,N2}\Big|_{T0}^{Ts}(T_s - T_0)$$

$$- c_{p,CH4}\Big|_{T0}^{T1}(T_1 - T_0) - \tilde{m}_{O2}\lambda c_{p,O2}\Big|_{T0}^{T2}(T_2 - T_0)$$

$$- \tilde{m}_{N2}\lambda c_{p,N2}\Big|_{T0}^{T2}(T_2 - T_0) - \Delta h_u^{CH4}(T_o)$$

$c_p$ : spezifische Wärmekapazität
$\Delta h_u$ : Heizwert
$\dot{Q}_v$ : Wärmeverluste
$T_0$ : Referenztemperatur
$T_1$ : statische Eintrittstemperatur des Brennstoffs
$T_2$ : statische Eintrittstemperatur der Luft
$T_s$ : statische Austrittstemperatur des Sekundärstrahls

Massenstroms von Brennstoff und Sekundärstrahl:

$$\lambda \rightarrow \dot{m}_{CH4} = \tilde{m}_{O2air}/(\tilde{m}_{O2}\lambda)\dot{m}_{air}, \qquad \dot{m}_s = \dot{m}_{air} + \dot{m}_{CH4}$$

e) Brennermodus:

Beispiel: Brennstoff $CH_4$:

$$\dot{V}_{CH4burn} = \frac{Power_{burn}}{\Delta h_u^{CH4}}, \qquad \dot{m}_{CH4burn} = \dot{V}_{CH4burn}\rho_{CH4burn}^N,$$

$$\dot{m}_{O2burn} = 2M_{O2}/M_{CH4}\dot{m}_{CH4burn}, \qquad \dot{V}_{O2burn} = \frac{\dot{m}_{O2burn}}{\rho_{O2burn}^N}$$

Power: Leistung
$\dot{V}$ : Volumenstrom
$\rho^N$ : Normdichte
$M_Y$ : Molmasse der Y-Komponente

f) Mit den berechneten Strömungsparametern des Sekundärstrahls und für gegebene Werte von $R_{s0}$, $R_1$, $R_2$ und $\alpha$ wird die äußere Koaxialdüse durch spezielle Konturfunktionen (Kreisbögen, Geraden, etc.) festgelegt, so dass eine möglichst ungestörte Unterschallströmung im Hüllgaskanal entsteht. Wesentliches Merkmal des Hüllgaskanals ist, dass das heiße Sekundärgas horizontal aus der Hüllgasdüse, d.h. parallel zum Primärgas austritt.

Im Folgenden wird exemplarisch eine typische Injektorauslegung vorgestellt. Die Randbedingungen, die für die Berechung vorgegeben werden, sind in diesem speziellen Fall:

**Injektormodus**

| | |
|---|---|
| Sauerstoff-Eintrittsdruck in die Primärdüse: | $p_0$ = 10 bar |
| Sauerstoffvolumenstrom der Primärdüse: | $\dot{V}_0$ = 50 Nm$^3$/min |
| Umgebungsdruck im EAF: | $p_\infty$ = 1.013 bar |

**Brennermodus**

Brennerleistung:   P = 6.00 MW

Als Ergebnis der Berechnung erhält man einen strömungstechnisch optimierten Injektor, bestehend aus zentraler Primärdüse und umgebender Hüllgas- bzw. Ringdüse.

**Bild 6** zeigt die Geometrie des Injektors für den besagten Injektor- oder Brennermodus, **Tabelle 1** enthält die zugehörigen Axial- und Radialkoordinaten der Koaxialdüse. Zu erkennen ist, das Primärgas und Sekundärgas parallel zueinander strömen. Dies ist das wesentliche Merkmal des mathematisch abgeleiteten Koaxialstrahlmodells.

**Tabelle 2** zeigt die für diese Düse berechneten strömungs- und thermodynamischen Kennzahlen. Gegenüber der Einzelstrahldüse wird die Länge $L_P^*$ des Überschallbereiches bei der Koaxialdüse um rd. 45% erhöht.

Es ergibt sich daraus eine Primärdüse und eine Sekundärdüse, die durch folgende Schar von Düsenformen in deren jeweiligem Auslegungsfall definiert sind:

**Injektor mit Koaxialstrahl, beispielsweise für einen Elektrolichtbogenofen (EAF)**

• **Primärdüse**

| | |
|---|---|
| Gas: | Sauerstoff |
| Eintrittsdruck in die Primärdüse: | $p_0 = 4 - 12$ bar |
| Eintrittsvolumenstrom : | $\dot{V}_0 = 20 - 100$ Nm$^3$/min |

• **Sekundärdüse**

| | |
|---|---|
| Gas: | CH$_4$, LPG |
| Machzahl am Düsenaustritt: | $M_s = 0.3 - 0.7$ |
| Temperatur am Düsenaustritt: | $T_s = 800 - 1200$ K |
| Spalthöhe am Düsenaustritt: | $H_s = 4 - 10$ mm |

Daraus ergibt sich folgende Schar an Formen der Koaxialdüse (für $p_\infty = 1.013$ bar = konst.):

Auslegungsfall definiert sind:

| Primärdüse *) | | | | | Sekundärdüse | | |
|---|---|---|---|---|---|---|---|
| Druck $p_0$ [bar] | Volumenstrom $V_0$ [Nm$^3$/min] | Radius im engsten Querschnitt r* [mm] | Austrittsradius $r_1$ [mm] | Düsenlänge l [mm] | Machzahl $M_s$ [-] | Temperatur $T_s$ [K] | Koaxialspalthöhe $H_s$ [mm] |
| 4 | 20 | 12.0 | 14.0 | 50 ± 20 | 0.5 ± 0.2 | 1000 ± 200 | 7 ± 3 |
| 4 | 200 | 39 | 44.0 | 160 ± 20 | 0.5 ± 0.2 | 1000 ± 200 | 7 ± 3 |
| 14 | 20 | 6 | 10.0 | 50 ± 20 | 0.5 ± 0.2 | 1000 ± 200 | 7 ± 3 |
| 14 | 200 | 21 | 33.0 | 160 ± 20 | 0.5 ± 0.2 | 1000 ± 200 | 7 ± 3 |
| *) Bezeichnungen siehe Bild 3a | | | | | | | |

**Tabelle 1:** Axialkoordinate (x) und Radialkoordinate (r) der in Bild 6 dargestellten Koaxialdüse, die mit dem neuen Koaxialstrahlmodell ausgelegt wurde

| Injektordüse (gemäß Bild 6) | | | | | | |
|---|---|---|---|---|---|---|
| Sauerstoff-Eintrittsdruck Primärdüse: $p_0$ = 10 bar | | | | | | |
| Sauerstoff-Volumenstrom Primärdüse: $\dot{v}_0$ = 50 Nm$^3$/min | | | | | | |
| Umgebungsdruck: $p_\infty$ = 1.013 bar | | | | | | |
| Brennerleistung: P = 6.00 MW | | | | | | |
| Koaxialdüse Außenkontur | | | Koaxialdüse Innenkontur | | | Primärdüse Innenkontur |
| x in mm | r in mm | | x in mm | r in mm | | x in mm | r in mm |
| -77.39 | 38.00 | | -77.39 | 62.00 | | -77.39 | 20.02 |
| -76.59 | 38.00 | | -76.59 | 62.00 | | -76.59 | 20.03 |
| -75.79 | 38.00 | | -75.79 | 62.00 | | -75.79 | 20.03 |
| -74.98 | 38.00 | | -74.98 | 62.00 | | -74.98 | 20.02 |
| -74.18 | 38.00 | | -74.18 | 62.00 | | -74.18 | 20.00 |
| -73.38 | 38.00 | | -73.38 | 62.00 | | -73.38 | 19.99 |
| -72.58 | 38.00 | | -72.58 | 62.00 | | -72.58 | 19.96 |
| -71.78 | 38.00 | | -71.78 | 62.00 | | -71.78 | 19.93 |
| -70.98 | 38.00 | | -70.98 | 62.00 | | -70.98 | 19.90 |
| -70.17 | 38.00 | | -70.17 | 62.00 | | -70.17 | 19.87 |
| -69.37 | 38.00 | | -69.37 | 62.00 | | -69.37 | 19.83 |
| -68.57 | 38.00 | | -68.57 | 62.00 | | -68.57 | 19.78 |
| -67.77 | 38.00 | | -67.77 | 62.00 | | -67.77 | 19.73 |
| -66.97 | 38.00 | | -66.97 | 62.00 | | -66.97 | 19.68 |
| -66.17 | 38.00 | | -66.17 | 62.00 | | -66.17 | 19.62 |
| -65.36 | 38.00 | | -65.36 | 62.00 | | -65.36 | 19.56 |
| -64.56 | 38.00 | | -64.56 | 62.00 | | -64.56 | 19.49 |
| -63.76 | 38.00 | | -63.76 | 62.00 | | -63.76 | 19.42 |
| -62.96 | 38.00 | | -62.96 | 62.00 | | -62.96 | 19.35 |
| -62.16 | 38.00 | | -62.16 | 62.00 | | -62.16 | 19.27 |
| -61.36 | 38.00 | | -61.36 | 62.00 | | -61.36 | 19.19 |
| -60.56 | 38.00 | | -60.56 | 62.00 | | -60.56 | 19.10 |
| -59.75 | 38.00 | | -59.75 | 62.00 | | -59.75 | 19.01 |
| -58.95 | 38.00 | | -58.95 | 62.00 | | -58.95 | 18.92 |
| -58.15 | 38.00 | | -58.15 | 62.00 | | -58.15 | 18.82 |
| -57.35 | 38.00 | | -57.35 | 62.00 | | -57.35 | 18.71 |
| -56.55 | 38.00 | | -56.55 | 62.00 | | -56.55 | 18.61 |
| -55.75 | 38.00 | | -55.75 | 62.00 | | -55.75 | 18.49 |
| -54.94 | 38.00 | | -54.94 | 62.00 | | -54.94 | 18.38 |
| -54.14 | 38.00 | | -54.14 | 62.00 | | -54.14 | 18.26 |
| -53.34 | 38.00 | | -53.34 | 62.00 | | -53.34 | 18.13 |

(fortgesetzt)

| Injektordüse (gemäß Bild 6) | | | | | | |
|---|---|---|---|---|---|---|
| Sauerstoff-Eintrittsdruck Primärdüse: $p_0$ = 10 bar<br>Sauerstoff-Volumenstrom Primärdüse: $\dot{v}_0$ = 50 Nm$^3$/min<br>Umgebungsdruck: $p_\infty$ = 1.013 bar<br>Brennerleistung: P = 6.00 MW | | | | | | |
| Koaxialdüse Außenkontur | | | Koaxialdüse Innenkontur | | | Primärdüse Innenkontur |
| -52.54 | 38.00 | | -52.54 | 62.00 | | -52.54 | 18.01 |
| -51.74 | 38.00 | | -51.74 | 62.00 | | -51.74 | 17.87 |
| -50.94 | 38.00 | | -50.94 | 62.00 | | -50.94 | 17.73 |
| -50.13 | 38.00 | | -50.13 | 62.00 | | -50.13 | 17.60 |
| -49.33 | 38.00 | | -49.33 | 62.00 | | -49.33 | 17.46 |
| -48.53 | 38.00 | | -48.53 | 62.00 | | -48.53 | 17.32 |
| -47.73 | 38.00 | | -47.73 | 62.00 | | -47.73 | 17.18 |
| -46.93 | 38.00 | | -46.93 | 62.00 | | -46.93 | 17.05 |
| -46.13 | 38.00 | | -46.13 | 62.00 | | -46.13 | 16.91 |
| -45.33 | 38.00 | | -45.33 | 62.00 | | -45.33 | 16.77 |
| -44.52 | 38.00 | | -44.52 | 62.00 | | -44.52 | 16.63 |
| -43.72 | 38.00 | | -43.72 | 62.00 | | -43.72 | 16.49 |
| -42.92 | 38.00 | | -42.92 | 62.00 | | -42.92 | 16.35 |
| -42.12 | 38.00 | | -42.12 | 62.00 | | -42.12 | 16.22 |
| -41.32 | 38.00 | | -41.32 | 62.00 | | -41.32 | 16.08 |
| -40.52 | 38.00 | | -40.52 | 62.00 | | -40.52 | 15.95 |
| -39.71 | 38.00 | | -39.71 | 62.00 | | -39.71 | 15.82 |
| -38.91 | 38.00 | | -38.91 | 62.00 | | -38.91 | 15.70 |
| -38.11 | 38.00 | | -38.11 | 62.00 | | -38.11 | 15.57 |
| -37.31 | 38.00 | | -37.31 | 62.00 | | -37.31 | 15.45 |
| -36.51 | 38.00 | | -36.51 | 62.00 | | -36.51 | 15.33 |
| -35.71 | 38.00 | | -35.71 | 62.00 | | -35.71 | 15.22 |
| -34.90 | 38.00 | | -34.90 | 62.00 | | -34.90 | 15.10 |
| -34.10 | 38.00 | | -34.10 | 62.00 | | -34.10 | 14.99 |
| -33.30 | 38.00 | | -33.30 | 62.00 | | -33.30 | 14.89 |
| -32.50 | 38.00 | | -32.50 | 62.00 | | -32.50 | 14.78 |
| -31.70 | 38.00 | | -31.70 | 62.00 | | -31.70 | 14.68 |
| -30.90 | 38.00 | | -30.90 | 62.00 | | -30.90 | 14.58 |
| -30.10 | 38.00 | | -30.10 | 62.00 | | -30.10 | 14.48 |
| -29.29 | 38.00 | | -29.29 | 62.00 | | -29.29 | 14.39 |
| -28.49 | 38.00 | | -28.49 | 62.00 | | -28.49 | 14.30 |
| -27.69 | 38.00 | | -27.69 | 62.00 | | -27.69 | 14.21 |
| -26.89 | 38.00 | | -26.89 | 62.00 | | -26.89 | 14.12 |

(fortgesetzt)

| Injektordüse (gemäß Bild 6) | | | | | | |
|---|---|---|---|---|---|---|
| Sauerstoff-Eintrittsdruck Primärdüse: $p_0$ = 10 bar<br>Sauerstoff-Volumenstrom Primärdüse: $\dot{v}_0$ = 50 Nm³/min<br>Umgebungsdruck: $p_\infty$ = 1.013 bar<br>Brennerleistung: P = 6.00 MW | | | | | | |
| Koaxialdüse Außenkontur | | | Koaxialdüse Innenkontur | | | Primärdüse Innenkontur | |
| -26.09 | 38.00 | | -26.09 | 62.00 | | -26.09 | 14.04 |
| -25.29 | 38.00 | | -25.29 | 62.00 | | -25.29 | 13.96 |
| -24.48 | 38.00 | | -24.48 | 62.00 | | -24.48 | 13.88 |
| -23.68 | 38.00 | | -23.68 | 62.00 | | -23.68 | 13.80 |
| -22.88 | 38.00 | | -22.88 | 62.00 | | -22.88 | 13.73 |
| -22.08 | 38.00 | | -22.08 | 62.00 | | -22.08 | 13.66 |
| -21.28 | 38.00 | | -21.28 | 62.00 | | -21.28 | 13.59 |
| -20.48 | 38.00 | | -20.48 | 62.00 | | -20.48 | 13.52 |
| -19.67 | 38.00 | | -19.67 | 62.00 | | -19.67 | 13.46 |
| -18.87 | 38.00 | | -18.87 | 62.00 | | -18.87 | 13.40 |
| -18.07 | 38.00 | | -18.07 | 62.00 | | -18.07 | 13.34 |
| -17.27 | 38.00 | | -17.27 | 62.00 | | -17.27 | 13.29 |
| -16.47 | 38.00 | | -16.47 | 62.00 | | -16.47 | 13.24 |
| -15.67 | 38.00 | | -15.67 | 62.00 | | -15.67 | 13.19 |
| -14.87 | 38.00 | | -14.87 | 62.00 | | -14.87 | 13.14 |
| -14.06 | 38.00 | | -14.06 | 62.00 | | -14.06 | 13.10 |
| -13.26 | 38.00 | | -13.26 | 62.00 | | -13.26 | 13.05 |
| -12.46 | 38.00 | | -12.46 | 62.00 | | -12.46 | 13.02 |
| -11.66 | 38.00 | | -11.66 | 62.00 | | -11.66 | 12.98 |
| -10.86 | 38.00 | | -10.86 | 62.00 | | -10.86 | 12.95 |
| -10.06 | 38.00 | | -10.06 | 62.00 | | -10.06 | 12.91 |
| -9.25 | 38.00 | | -9.25 | 62.00 | | -9.25 | 12.89 |
| -8.45 | 38.00 | | -8.45 | 62.00 | | -8.45 | 12.86 |
| -7.65 | 38.00 | | -7.65 | 62.00 | | -7.65 | 12.84 |
| -6.85 | 38.00 | | -6.85 | 62.00 | | -6.85 | 12.82 |
| -6.05 | 38.00 | | -6.05 | 62.00 | | -6.05 | 12.80 |
| -5.25 | 38.00 | | -5.25 | 62.00 | | -5.25 | 12.78 |
| -4.44 | 38.00 | | -4.44 | 62.00 | | -4.44 | 12.77 |
| -3.64 | 38.00 | | -3.64 | 62.00 | | -3.64 | 12.76 |
| -2.84 | 38.00 | | -2.84 | 62.00 | | -2.84 | 12.75 |
| -2.04 | 38.00 | | -2.04 | 62.00 | | -2.04 | 12.75 |
| -1.24 | 38.00 | | -1.24 | 62.00 | | -1.24 | 12.74 |
| -0.44 | 38.00 | | -0.44 | 62.00 | | -0.44 | 12.74 |

(fortgesetzt)

| Injektordüse (gemäß Bild 6) | | | | | | | |
|---|---|---|---|---|---|---|---|
| Sauerstoff-Eintrittsdruck Primärdüse: $p_0$ = 10 bar | | | | | | | |
| Sauerstoff-Volumenstrom Primärdüse: $\dot{v}_0$ = 50 Nm³/min | | | | | | | |
| Umgebungsdruck: $p_\infty$ = 1.013 bar | | | | | | | |
| Brennerleistung: P = 6.00 MW | | | | | | | |
| Koaxialdüse Außenkontur | | | Koaxialdüse Innenkontur | | | Primärdüse Innenkontur | |
| 0.36 | 38.00 | | 0.36 | 62.00 | | 0.36 | 12.75 |
| 1.17 | 38.00 | | 1.17 | 62.00 | | 1.17 | 12.75 |
| 1.97 | 38.00 | | 1.97 | 62.00 | | 1.97 | 12.76 |
| 2.77 | 38.00 | | 2.77 | 62.00 | | 2.77 | 12.77 |
| 3.57 | 38.00 | | 3.57 | 62.00 | | 3.57 | 12.79 |
| 4.37 | 38.00 | | 4.37 | 62.00 | | 4.37 | 12.80 |
| 5.17 | 38.00 | | 5.17 | 62.00 | | 5.17 | 12.82 |
| 5.98 | 38.00 | | 5.98 | 62.00 | | 5.98 | 12.85 |
| 6.78 | 38.00 | | 6.78 | 62.00 | | 6.78 | 12.87 |
| 7.58 | 38.00 | | 7.58 | 62.00 | | 7.58 | 12.90 |
| 8.38 | 38.00 | | 8.38 | 62.00 | | 8.38 | 12.93 |
| 9.18 | 38.00 | | 9.18 | 62.00 | | 9.18 | 12.96 |
| 9.98 | 38.00 | | 9.98 | 62.00 | | 9.98 | 13.00 |
| 10.79 | 38.00 | | 10.79 | 62.00 | | 10.79 | 13.03 |
| 11.59 | 38.00 | | 11.59 | 62.00 | | 11.59 | 13.08 |
| 12.39 | 38.00 | | 12.39 | 62.00 | | 12.39 | 13.12 |
| 13.19 | 38.00 | | 13.19 | 62.00 | | 13.19 | 13.17 |
| 13.99 | 38.00 | | 13.99 | 62.00 | | 13.99 | 13.21 |
| 14.79 | 38.00 | | 14.79 | 62.00 | | 14.79 | 13.27 |
| 15.59 | 38.00 | | 15.59 | 62.00 | | 15.59 | 13.32 |
| 16.40 | 38.00 | | 16.40 | 62.00 | | 16.40 | 13.38 |
| 17.20 | 38.00 | | 17.20 | 62.00 | | 17.20 | 13.44 |
| 18.00 | 38.00 | | 18.00 | 62.00 | | 18.00 | 13.50 |
| 18.80 | 38.00 | | 18.80 | 62.00 | | 18.80 | 13.56 |
| 19.60 | 38.00 | | 19.60 | 62.00 | | 19.60 | 13.63 |
| 20.40 | 38.00 | | 20.40 | 62.00 | | 20.40 | 13.70 |
| 21.21 | 38.00 | | 21.21 | 61.98 | | 21.21 | 13.78 |
| 22.01 | 38.00 | | 22.01 | 61.96 | | 22.01 | 13.85 |
| 22.81 | 38.00 | | 22.81 | 61.92 | | 22.81 | 13.93 |
| 23.61 | 38.00 | | 23.61 | 61.86 | | 23.61 | 14.01 |
| 24.41 | 38.00 | | 24.41 | 61.80 | | 24.41 | 14.10 |
| 25.21 | 38.00 | | 25.21 | 61.72 | | 25.21 | 14.18 |
| 26.02 | 38.00 | | 26.02 | 61.63 | | 26.02 | 14.27 |

(fortgesetzt)

| Injektordüse (gemäß Bild 6) | | | | | | |
|---|---|---|---|---|---|---|
| Sauerstoff-Eintrittsdruck Primärdüse: $p_0$ = 10 bar | | | | | | |
| Sauerstoff-Volumenstrom Primärdüse: $\dot{v}_0$ = 50 Nm³/min | | | | | | |
| Umgebungsdruck: $p_\infty$ = 1.013 bar | | | | | | |
| Brennerleistung: P = 6.00 MW | | | | | | |
| Koaxialdüse Außenkontur | | | Koaxialdüse Innenkontur | | | Primärdüse Innenkontur |
| 26.82 | 38.00 | | 26.82 | 61.52 | | 26.82 | 14.37 |
| 27.62 | 38.00 | | 27.62 | 61.40 | | 27.62 | 14.46 |
| 28.42 | 38.00 | | 28.42 | 61.27 | | 28.42 | 14.56 |
| 29.22 | 38.00 | | 29.22 | 61.13 | | 29.22 | 14.65 |
| 30.02 | 38.00 | | 30.02 | 60.97 | | 30.02 | 14.75 |
| 30.82 | 38.00 | | 30.82 | 60.80 | | 30.82 | 14.84 |
| 31.63 | 38.00 | | 31.63 | 60.61 | | 31.63 | 14.94 |
| 32.43 | 38.00 | | 32.43 | 60.41 | | 32.43 | 15.04 |
| 33.23 | 38.00 | | 33.23 | 60.20 | | 33.23 | 15.13 |
| 34.03 | 38.00 | | 34.03 | 59.97 | | 34.03 | 15.22 |
| 34.83 | 38.00 | | 34.83 | 59.73 | | 34.83 | 15.32 |
| 35.63 | 38.00 | | 35.63 | 59.47 | | 35.63 | 15.41 |
| 36.44 | 37.99 | | 36.44 | 59.20 | | 36.44 | 15.50 |
| 37.24 | 37.96 | | 37.24 | 58.91 | | 37.24 | 15.59 |
| 38.04 | 37.92 | | 38.04 | 58.60 | | 38.04 | 15.68 |
| 38.84 | 37.86 | | 38.84 | 58.28 | | 38.84 | 15.76 |
| 39.64 | 37.78 | | 39.64 | 57.95 | | 39.64 | 15.85 |
| 40.44 | 37.69 | | 40.44 | 57.60 | | 40.44 | 15.93 |
| 41.25 | 37.58 | | 41.25 | 57.23 | | 41.25 | 16.02 |
| 42.05 | 37.45 | | 42.05 | 56.84 | | 42.05 | 16.10 |
| 42.85 | 37.31 | | 42.85 | 56.44 | | 42.85 | 16.18 |
| 43.65 | 37.15 | | 43.65 | 56.01 | | 43.65 | 16.26 |
| 44.45 | 36.97 | | 44.45 | 55.57 | | 44.45 | 16.33 |
| 45.25 | 36.78 | | 45.25 | 55.11 | | 45.25 | 16.41 |
| 46.05 | 36.57 | | 46.05 | 54.63 | | 46.05 | 16.48 |
| 46.86 | 36.34 | | 46.86 | 54.13 | | 46.86 | 16.55 |
| 47.66 | 36.09 | | 47.66 | 53.60 | | 47.66 | 16.62 |
| 48.46 | 35.83 | | 48.46 | 53.06 | | 48.46 | 16.69 |
| 49.26 | 35.54 | | 49.26 | 52.49 | | 49.26 | 16.76 |
| 50.06 | 35.24 | | 50.06 | 51.90 | | 50.06 | 16.82 |
| 50.86 | 34.91 | | 50.86 | 51.28 | | 50.86 | 16.88 |
| 51.67 | 34.57 | | 51.67 | 50.63 | | 51.67 | 16.94 |
| 52.47 | 34.20 | | 52.47 | 49.96 | | 52.47 | 17.00 |

(fortgesetzt)

| Injektordüse (gemäß Bild 6) | | | | | | |
|---|---|---|---|---|---|---|
| Sauerstoff-Eintrittsdruck Primärdüse: $p_0$ = 10 bar<br>Sauerstoff-Volumenstrom Primärdüse: $\dot{v}_0$ = 50 Nm$^3$/min<br>Umgebungsdruck: $p_\infty$ = 1.013 bar<br>Brennerleistung: P = 6.00 MW | | | | | | |
| Koaxialdüse Außenkontur | | | Koaxialdüse Innenkontur | | Primärdüse Innenkontur | |
| 53.27 | 33.81 | | 53.27 | 49.26 | 53.27 | 17.06 |
| 54.07 | 33.40 | | 54.07 | 48.53 | 54.07 | 17.12 |
| 54.87 | 32.97 | | 54.87 | 47.76 | 54.87 | 17.17 |
| 55.67 | 32.51 | | 55.67 | 46.96 | 55.67 | 17.23 |
| 56.48 | 32.05 | | 56.48 | 46.16 | 56.48 | 17.28 |
| 57.28 | 31.59 | | 57.28 | 45.36 | 57.28 | 17.33 |
| 58.08 | 31.13 | | 58.08 | 44.56 | 58.08 | 17.37 |
| 58.88 | 30.66 | | 58.88 | 43.76 | 58.88 | 17.42 |
| 59.68 | 30.20 | | 59.68 | 42.96 | 59.68 | 17.46 |
| 60.48 | 29.74 | | 60.48 | 42.15 | 60.48 | 17.51 |
| 61.28 | 29.29 | | 61.28 | 41.35 | 61.28 | 17.55 |
| 62.09 | 28.86 | | 62.09 | 40.55 | 62.09 | 17.59 |
| 62.89 | 28.45 | | 62.89 | 39.75 | 62.89 | 17.62 |
| 63.69 | 28.05 | | 63.69 | 38.95 | 63.69 | 17.66 |
| 64.49 | 27.68 | | 64.49 | 38.15 | 64.49 | 17.70 |
| 65.29 | 27.32 | | 65.29 | 37.41 | 65.29 | 17.73 |
| 66.09 | 26.97 | | 66.09 | 36.71 | 66.09 | 17.76 |
| 66.90 | 26.65 | | 66.90 | 36.06 | 66.90 | 17.79 |
| 67.70 | 26.34 | | 67.70 | 35.46 | 67.70 | 17.82 |
| 68.50 | 26.04 | | 68.50 | 34.90 | 68.50 | 17.85 |
| 69.30 | 25.77 | | 69.30 | 34.37 | 69.30 | 17.87 |
| 70.10 | 25.50 | | 70.10 | 33.88 | 70.10 | 17.89 |
| 70.90 | 25.25 | | 70.90 | 33.43 | 70.90 | 17.92 |
| 71.71 | 25.02 | | 71.71 | 33.00 | 71.71 | 17.94 |
| 72.51 | 24.80 | | 72.51 | 32.61 | 72.51 | 17.96 |
| 73.31 | 24.59 | | 73.31 | 32.25 | 73.31 | 17.98 |
| 74.11 | 24.40 | | 74.11 | 31.91 | 74.11 | 18.00 |
| 74.91 | 24.22 | | 74.91 | 31.60 | 74.91 | 18.01 |
| 75.71 | 24.06 | | 75.71 | 31.32 | 75.71 | 18.03 |
| 76.51 | 23.91 | | 76.51 | 31.06 | 76.51 | 18.04 |
| 77.32 | 23.77 | | 77.32 | 30.82 | 77.32 | 18.05 |
| 78.12 | 23.65 | | 78.12 | 30.61 | 78.12 | 18.06 |
| 78.92 | 23.54 | | 78.92 | 30.42 | 78.92 | 18.07 |

(fortgesetzt)

| Injektordüse (gemäß Bild 6) | | | | | | | |
|---|---|---|---|---|---|---|---|
| Sauerstoff-Eintrittsdruck Primärdüse: $p_0$ = 10 bar<br>Sauerstoff-Volumenstrom Primärdüse: $\dot{v}_0$ = 50 Nm$^3$/min<br>Umgebungsdruck: $p_\infty$ = 1.013 bar<br>Brennerleistung: P = 6.00 MW | | | | | | | |
| Koaxialdüse Außenkontur | | | Koaxialdüse Innenkontur | | | Primärdüse Innenkontur | |
| 79.72 | 23.44 | | 79.72 | 30.26 | | 79.72 | 18.08 |
| 80.52 | 23.36 | | 80.52 | 30.12 | | 80.52 | 18.09 |
| 81.32 | 23.29 | | 81.32 | 30.00 | | 81.32 | 18.10 |
| 82.13 | 23.23 | | 82.13 | 29.90 | | 82.13 | 18.11 |
| 82.93 | 23.18 | | 82.93 | 29.83 | | 82.93 | 18.11 |
| 83.73 | 23.15 | | 83.73 | 29.77 | | 83.73 | 18.12 |
| 84.53 | 23.13 | | 84.53 | 29.74 | | 84.53 | 18.12 |
| 85.33 | 23.13 | | 85.33 | 29.73 | | 85.33 | 18.13 |

**Tabelle 2:** Strömungs- und thermodynamische Randbedingungen für die in Bild 6 und Tabelle 1 gezeigte Koaxialdüse, die mit dem neuen Koaxialstrahlmodell ausgelegt wurde.

| Injektormodus: Sauerstoff-Eintrittsdruck Primärdüse: $p_0$ = 10 bar<br>Sauerstoff-Volumenstrom Primärdüse: $\dot{V}_0$ = 50 Nm$^3$/min<br>Umgebungsdruck: $p_\infty$ = 1.013 bar<br>Brennermodus: Brennerleistung: P = 6.00 MW | | | | | | | | | | | |
|---|---|---|---|---|---|---|---|---|---|---|---|
| Injektormodus | | | | | | Brennermodus | | | | | |
| Primärstrahl | | | Sekundärstrahl | | | Primärstrahl | | | Sekundärstrahl | | |
| $M_p$ | - | 2.149 | $M_s$ | - | 0.482 | P | MW | 6.00 | | | |
| $T_p$ | K | 152.9 | $T_s$ | K | 1100.0 | $\dot{V}_{p,O2}$ | Nm$^3$/h | 1205 .6 | $\dot{V}_{s,CH4}$ | Nm$^3$/h | 601. 9 |
| $\dot{V}_p$ | Nm$^3$/h | 3000 | $H_s$ | m | 0.006 64 | $\dot{m}_{p,O2}$ | kg/s | 0.47 86 | $\dot{m}_{p,CH4}$ | kg/s | 0.12 00 |
| $u_p$ | m/s | 506.2 | $\dot{V}_s$ | Nm$^3$/h | 311.0 | | | | | | |
| $p_p$ | Pa | 1013 25 | $\dot{V}_{s,CH4}$ | Nm$^3$/h | 11.0 | | | | | | |
| | | | $\dot{V}_{s,air}$ | Nm$^3$/h | 300 | | | | | | |
| | | | $T_{0,s}$ | K | 1144. 7 | | | | | | |
| | | | $u_s$ | m/s | 317.8 | | | | | | |
| | | | $p_s$ | Pa | 10132 5 | | | | | | |
| | | | $\dot{m}_s$ | kg/s | 0.109 9 | | | | | | |
| | | | $\dot{m}_{s,CH4}$ | kg/s | 0.002 2 | | | | | | |

(fortgesetzt)

| | Injektormodus | | | | | Brennermodus | | | | |
|---|---|---|---|---|---|---|---|---|---|---|
| | Primärstrahl | | Sekundärstrahl | | | Primärstrahl | | | Sekundärstrahl | |
| | | | $\dot{m}_{s,air}$ | kg/s | 0.1077 | | | | | |
| | | | $p_{0,s}$ | Pa | 118162 | | | | | |
| Überschalllänge:<br>$L^{*}_{p,single} = 1.107$ m , $L^{*}_{p,coaxial} = 1.608$ m | | | | | | | | | | |

Bezugszeichenliste:

| | |
|---|---|
| 1-1 | Kühlwasserleitungen |
| 1-2 | Kühlwasserkanal |
| 1-3 | zurückversetzte Lavaldüse |
| 1-4 | Brenner/Injektordüse |
| 1-5 | Flammengenerator |
| 1-6 | Luftleitung |
| 1-7 | Natürliche Gasleitung |
| 1-8 | Sauerstoffleitung |
| 1-9 | Schnellverbinder |

| | |
|---|---|
| 2a-1 | Heißgas-Erzeuger |
| 2a-2 | verdichtete Luft |
| 2a-3 | Heißer Mantel - (Hüll-) Strahl |

| | |
|---|---|
| 2b-1 | Flamme |

| | |
|---|---|
| 2c-1 | Heißgas-Erzeuger |
| 2c-2 | verdichtete Luft |
| 2c-3 | Heißer Mantelstrahl |
| 2c-4 | zentraler mittiger Überschallstrahl |

| | |
|---|---|
| 3a-1 | heiße Ofenumgebung |
| 3a-2 | Unterschall |
| 3a-3 | Überschall ($L_p$) |
| 3a-4 | Strahlkern |
| 3a-5 | Primärgas (p) |
| 3b-1 | Lavaldüse Innenkontur |
| 3b-2 | Koaxialspalt Außenkontur |
| 3b-3 | Koaxialspalt Innenkontur |
| 3b-4 | Sekundärgas (s) |
| 3b-5 | Primärgas (p) |

| | |
|---|---|
| 4-1 | Düsenwand (Cu) |
| 4-2 | Koaxialspalt Außenkontur |
| 4-3 | Sekundärgas (s) |
| 4-4 | Düsenwand (Cu) |
| 4-5 | Koaxialspalt Innenkontur |
| 4-6 | Primärgas (p) |
| 4-7 | Lavaldüse Innenkontur |
| 4-8 | Symmetrieachse |

4-9 Umgebung (∞)

5-1 Heißer Sekundärstrahl (s)
5-2 Kalter Primärstrahl (p)
5-3 Heißer Sekundärstrahl (s)
5-4 Heiße Umgebung (∞)

6-1 Koaxialspalt außen
6-2 Koaxialspalt innen
6-3 Lavaldüse innen


**Patentansprüche**

1. Injektor zum Einsatz in metallurgischen Anlagen, insbesondere in einem Basic Oxygen Furnace (BOF), in einem Argon Oxygen Decarburization (AOD) Konverter oder in einem Elektrolichtbogenofen (EAF), mit einer als Überschalldüse ausgelegten Primärdüse zum Aufblasen eines sauerstoffreichen Gases auf eine Metallschmelze und einer koaxial zur Primärdüse angeordneten Sekundärdüse zum Erzeugen eines den aus der Primärdüse austretenden Gasstrahl umgebenden Koaxialstrahls, wobei die Primärdüse einen konvergenten Abschnitt und einen divergenten Abschnitt aufweist, welche in einem Radius des engsten Querschnitts r* aneinander angrenzen, wobei bei der Primärdüse das Verhältnis einer Düsenlänge l zum Radius im engsten Querschnitt r*, also l/r*, zwischen 2,1 und 11,6, bevorzugt zwischen 2,1 und 8,3, noch bevorzugter zwischen 2,1 und 5,4, noch bevorzugter zwischen 2,1 und 5,0 liegt, und insbesondere Werte von 11,6, 8,3, 5,4, 5,0, 4,8, 4,2, 4,1, 3,6, 3,3, 3,1 oder 2,1 aufweist, **dadurch gekennzeichnet, dass** die Primärdüse und die Sekundärdüse durch folgende Schar von Düsenformen in deren jeweiligem Auslegungsfall definiert sind:

| Primärdüse | | | | Sekundärdüse | | | |
|---|---|---|---|---|---|---|---|
| Druck $p_0$ [bar] | Volumenstrom $V_0$ [Nm³/min] | Radius im engsten Querschnitt $r^*$ [mm] | Austrittsradius $r_1$ [mm] | Düsenlänge $l$ [mm] | Machzahl $M_s$ [-] | Temperatur $T_s$ [K] | Koaxialspalthöhe $H_s$ [mm] |
| 4 | 20 | 12.0 | 14.0 | 50 ± 20 | 0.5 ± 0.2 | 1000 ± 200 | 7 ± 3 |
| 4 | 200 | 39 | 44.0 | 160 ± 20 | 0.5 ± 0.2 | 1000 ± 200 | 7 ± 3 |
| 14 | 20 | 6 | 10.0 | 50 ± 20 | 0.5 ± 0.2 | 1000 ± 200 | 7 ± 3 |
| 14 | 200 | 21 | 33.0 | 160 ± 20 | 0.5 ± 0.2 | 1000 ± 200 | 7 ± 3 |

2. Injektor zum Einsatz in metallurgischen Anlagen, insbesondere in einem Basic Oxygen Furnace (BOF), in einem Argon Oxygen Decarburization (AOD) Konverter oder in einem Elektrolichtbogenofen (EAF), mit einer als Überschalldüse ausgelegten Primärdüse zum Aufblasen eines sauerstoffreichen Gases auf eine Metallschmelze und einer koaxial zur Primärdüse angeordneten Sekundärdüse zum Erzeugen eines den aus der Primärdüse austretenden Gasstrahl umgebenden Koaxialstrahls, wobei die Primärdüse einen konvergenten Abschnitt und einen divergenten Abschnitt aufweist, welche in einem Radius des engsten Querschnitts r* aneinander angrenzen, **dadurch gekennzeichnet, dass** die Innenkontur und die Außenkontur der Sekundärdüse nummerisch so bestimmt wird, dass die konvektive Machzahl $M_{c\infty s}$ zwischen Umgebung ($\infty$) und dem durch die Sekundärdüse erzeugten Sekundärstrahl (s) gleich ist mit der konvektiven Machzahl $M_{csp}$ zwischen dem Sekundärstrahl (s) und dem durch die Primärdüse erzeugten Primärstrahl (p):

$$M_{c\infty s} = M_{csp},$$

wobei die nummerische Bestimmung die Schritte aufweist:

a) Bestimmung der konvektiven Machzahlen:

Einzelstrahl (Single-Jet): $M_{c\infty p}$ zwischen Umgebung und Primärstrahl

$$M_{c\infty p} = \frac{M_p \sqrt{\rho_\infty / \rho_p}}{(1 + \sqrt{\rho_\infty / \rho_p})(\gamma_\infty / \gamma_p)^{1/4}}$$

Koaxialstrahl: $M_{c\infty s}$ zwischen Umgebung und Sekundärstrahl sowie $M_{csp}$ zwischen Sekundärstrahl und Primärstrahl

$$M_{c\infty s} = \frac{M_s \sqrt{\rho_\infty / \rho_s}}{(1 + \sqrt{\rho_\infty / \rho_s})(\gamma_\infty / \gamma_s)^{1/4}}, \qquad M_{csp} = \frac{M_p \sqrt{\rho_s / \rho_p}(1 - u_s / u_p)}{(1 + \sqrt{\rho_s / \rho_p})(\gamma_s / \gamma_p)^{1/4}}$$

b) Bestimmung des optimalen Betriebsparameters für den Koaxialstrahl, gültig für kalten Primärstrahl, heißen Sekundärstrahl und heiße Umgebung. Neues Optimierungs-Kriterium:

$$M_{c\infty s} = M_{csp}$$

Machzahl des Sekundärstrahls:

$$M_s = \frac{u_s}{a_s} = \frac{u_p}{a_s}\left[1 + \frac{a_p}{a_s}\left(\frac{1 + \sqrt{\rho_p / \rho_s}}{1 + \sqrt{\rho_s / \rho_\infty}}\right)\left(\frac{\gamma_p \gamma_\infty}{\gamma_s^2}\right)^{-1/4}\right]^{-1}$$

c) Bestimmung des neuen Korrelationsmodells für den Koaxialstrahl, gültig für kalten Primärstrahl, heißen Sekundärstrahl und heiße Umgebung.
Funktionen der konvektiven Machzahl:

$$F_{\infty p} = M_{c\infty p}^2, \qquad F_{sp} = M_{csp}^2, \qquad F_{\infty s} = M_{c\infty s}^2,$$

Schalter- und Geometrie-Funktionen:

$$F_{\infty sp} = \alpha\left(\frac{F_{sp}F_{\infty s}}{\beta F_{sp} + F_{\infty s}}\right), \quad F_p = 1 + \frac{F_{\infty sp}}{F_{sp}F_{\infty p}}\left(F_{sp} - F_{\infty p}\right), \quad F_h = 1 + \sigma\left(H_s / D_p\right),$$

Funktion der Strahllänge:

$$\frac{\overset{\cdot}{L_p}}{\overset{\cdot}{L_{single}}} = \varphi F_h \cdot \exp\left[-\theta \cdot abs\left(F_p\right)\right].$$

3. Injektor gemäß Anspruch 1 oder 2, **dadurch gekennzeichnet, dass** die Primärdüse zur Verwendung mit Sauerstoff und die Sekundärdüse zur Verwendung mit $CH_4$ oder LPG bestimmt sind.

4. Injektor gemäß einem der vorstehenden Ansprüche, **dadurch gekennzeichnet, dass** die Sekundärdüse als Unterschalldüse ausgelegt ist.

5. Injektor gemäß einem der vorstehenden Ansprüche, **dadurch gekennzeichnet, dass** ein mit der Sekundärdüse gekoppelter Heißgaserzeuger vorgesehen ist, welcher über die Sekundärdüse einen Sekundärstrahl an heißem Verbrennungsgas bereitstellt.

6. Injektor gemäß Anspruch 5, **dadurch gekennzeichnet, dass** der Heizgaserzeuger so steuerbar ist, dass die für die Auslegung der Sekundärdüse und der Primärdüse optimierte Menge an Abgas bei einer optimierten Abgastemperatur erreicht wird.

7. Injektor gemäß einem der vorstehenden Ansprüche, dadurch gekennzeichet, dass die Innenkontur der Primärdüse der auf numerischem Wege mit einem modifizierten Charakteristikenverfahren ermittelten Kontur entspricht.

8. Injektor gemäß einem der vorstehenden Ansprüche, **dadurch gekennzeichnet, dass** die Innenkontur der Primärdüse der ermittelten Kontur entspricht, die durch numerische Lösung der partiellen gasdynamischen Differentialgleichungen ermittelt wird, bei welchen die stationäre, isentrope, rotationssymmetrische Gasströmung mittels räumlich diskretisierten Charakteristikengleichungen unter Berücksichtigung entsprechender Kompatibilitätsbedingungen dargestellt ist.

9. Injektor gemäß Anspruch 8, **dadurch gekennzeichnet, dass** bei der Lösung der partiellen numerischen Differentialgleichungen der Einfluss einer reibungsbehafteten, wandnahen Grenzschichtströmung berücksichtigt wird.

10. Injektor gemäß einem der vorstehenden Ansprüche, **dadurch gekennzeichnet, dass** bei der Primärdüse der konvergente Abschnitt eine glockenförmige Kontur aufweist und der divergente Abschnitt eine glockenförmige Kontur aufweist, wobei die glockenförmigen Konturen des konvergenten Abschnittes und des divergenten Abschnittes an der Düsenkehle stetig ineinander übergehen.

11. Injektor gemäß einem der vorstehenden Ansprüche, **dadurch gekennzeichnet, dass** die Primärdüse einen konvergenten Unterschallteil und einen divergenten Überschallteil aufweist und die Innenkontur einer mit einem modifizierten Charakteristikenverfahren ermittelten Kontur entspricht, die einen langen Überschallbereich $\overset{\cdot}{L_p}$ erzeugt, und die Sekundärdüse ausgehend davon eine Innenkontur und eine Außenkontur in der Form aufweist, die auf numerischem Wege sowohl die gesamte Geometrie als auch die thermischen Prozessgrößen des Koaxialgases so einbeziehen, dass die Überschalllänge $\overset{\cdot}{L_p}$ des Primärstrahls weiter verlängert wird.

12. Injektor gemäß einem der vorstehenden Ansprüche, **dadurch gekennzeichnet, dass** er in einem Injektormodus und einem Brennermodus betreibbar ist, wobei im Injektormodus ein sauerstoffreicher Primärstrahl, der von einem dazu koaxialen Sekundärstrahl eingehüllt ist, auf eine Metallschmelze aufbringbar ist, und im Brennermodus $CH_4$ oder LPG über die Sekundärdüse und ein sauerstoffreiches Gas über die Primärdüse so zuführbar sind, dass ein Brennstrahl erzeugt wird.

13. Injektor gemäß Anspruch 12, **gekennzeichnet durch** die nachfolgenden Betriebsparameter im Injektormodus und im Brennermodus:

**Injektormodus:** Sauerstoff-Eintrittsdruck Primärdüse: $p_0 = 10$ bar

Sauerstoff-Volumenstrom Primärdüse: $\dot{V}_0 = 50$ Nm$^3$/min

Umgebungsdruck: $p_\infty = 1.013$ bar

**Brennermodus:** Brennerleistung: $P = 6.00$ MW

| Injektormodus | | | | | | Brennermodus | | | | | |
|---|---|---|---|---|---|---|---|---|---|---|---|
| Primärstrahl | | | Sekundärstrahl | | | Primärstrahl | | | Sekundärstrahl | | |
| $M_p$ | - | 2.149 | $M_s$ | - | 0.482 | P | MW | 6.00 | | | |
| $T_p$ | K | 152.9 | $T_s$ | K | 1100.0 | $\dot{V}_{p,O2}$ | Nm$^3$/h | 1205. 6 | $\dot{V}_{s,CH4}$ | Nm$^3$/h | 601.9 |
| $\dot{V}_p$ | Nm$^3$/h | 3000 | $H_s$ | m | 0.0066 4 | $\dot{m}_{p,O2}$ | kg/s | 0.478 6 | $\dot{m}_{p,CH4}$ | kg/s | 0.1200 |
| $u_p$ | m/s | 506.2 | $\dot{V}_s$ | Nm$^3$/h | 311.0 | | | | | | |
| $p_p$ | Pa | 10132 5 | $\dot{V}_{s,CH4}$ | Nm$^3$/h | 11.0 | | | | | | |
| | | | $\dot{V}_{s,air}$ | Nm$^3$/h | 300 | | | | | | |
| | | | $T_{0,s}$ | K | 1144.7 | | | | | | |
| | | | $u_s$ | m/s | 317.8 | | | | | | |
| | | | $p_s$ | Pa | 101325 | | | | | | |
| | | | $\dot{m}_s$ | kg/s | 0.1099 | | | | | | |
| | | | $\dot{m}_{s,CH4}$ | kg/s | 0.0022 | | | | | | |
| | | | $\dot{m}_{s,air}$ | kg/s | 0.1077 | | | | | | |
| | | | $p_{0,s}$ | Pa | 118162 | | | | | | |
| Überschalllänge: $\dot{L}_{p,single} = 1.107$ m , $\dot{L}_{p,coaxial} = 1.608$ m | | | | | | | | | | | |

14. Injektor zum Einsatz in metallurgischen Anlagen, insbesondere in einem Basic Oxygen Furnace (BOF), in einem Argon Oxygen Decarburization (AOD) Konverter oder in einem Elektrolichtbogenofen (EAF), mit einer als Überschalldüse ausgelegten Primärdüse zum Aufblasen eines sauerstoffreichen Gases auf eine Metallschmelze und einer koaxial zur Primärdüse angeordneten Sekundärdüse zum Erzeugen eines den aus der Primärdüse austretenden Gasstrahl umgebenden Koaxialstrahls, wobei die Primärdüse einen konvergenten Abschnitt und einem divergenten Abschnitt aufweist, welche in einem Radius des engsten Querschnitts r* aneinander angrenzen, **gekennzeichnet durch** die folgenden Dimensionen im folgenden Auslegungsfall für Axialkoordinate (x) und Radialkoordinate (r):

| Injektor | | | | | | | |
|---|---|---|---|---|---|---|---|
| Sauerstoff-Eintrittsdruck Primärdüse: $p_0 = 10$ bar | | | | | | | |
| Sauerstoff-Volumenstrom Primärdüse: $\dot{v}_0 = 50$ Nm$^3$/min | | | | | | | |
| Umgebungsdruck: $p_\infty = 1.013$ bar | | | | | | | |
| Brennerleistung: $P = 6.00$ MW | | | | | | | |
| Sekundärdüse Außenkontur | | | Skundärdüse Innenkontur | | | Primärdüse Innenkontur | |
| x in mm | r in mm | | x in mm | r in mm | | x in mm | r in mm |
| -77.39 | 38.00 | | -77.39 | 62.00 | | -77.39 | 20.02 |

(fortgesetzt)

| Sekundärdüse Außenkontur | | | Skundärdüse Innenkontur | | | Primärdüse Innenkontur | |
|---|---|---|---|---|---|---|---|
| x in mm | r in mm | | x in mm | r in mm | | x in mm | r in mm |
| -76.59 | 38.00 | | -76.59 | 62.00 | | -76.59 | 20.03 |
| -75.79 | 38.00 | | -75.79 | 62.00 | | -75.79 | 20.03 |
| -74.98 | 38.00 | | -74.98 | 62.00 | | -74.98 | 20.02 |
| -74.18 | 38.00 | | -74.18 | 62.00 | | -74.18 | 20.00 |
| -73.38 | 38.00 | | -73.38 | 62.00 | | -73.38 | 19.99 |
| -72.58 | 38.00 | | -72.58 | 62.00 | | -72.58 | 19.96 |
| -71.78 | 38.00 | | -71.78 | 62.00 | | -71.78 | 19.93 |
| -70.98 | 38.00 | | -70.98 | 62.00 | | -70.98 | 19.90 |
| -70.17 | 38.00 | | -70.17 | 62.00 | | -70.17 | 19.87 |
| -69.37 | 38.00 | | -69.37 | 62.00 | | -69.37 | 19.83 |
| -68.57 | 38.00 | | -68.57 | 62.00 | | -68.57 | 19.78 |
| -67.77 | 38.00 | | -67.77 | 62.00 | | -67.77 | 19.73 |
| -66.97 | 38.00 | | -66.97 | 62.00 | | -66.97 | 19.68 |
| -66.17 | 38.00 | | -66.17 | 62.00 | | -66.17 | 19.62 |
| -65.36 | 38.00 | | -65.36 | 62.00 | | -65.36 | 19.56 |
| -64.56 | 38.00 | | -64.56 | 62.00 | | -64.56 | 19.49 |
| -63.76 | 38.00 | | -63.76 | 62.00 | | -63.76 | 19.42 |
| -62.96 | 38.00 | | -62.96 | 62.00 | | -62.96 | 19.35 |
| -62.16 | 38.00 | | -62.16 | 62.00 | | -62.16 | 19.27 |
| -61.36 | 38.00 | | -61.36 | 62.00 | | -61.36 | 19.19 |
| -60.56 | 38.00 | | -60.56 | 62.00 | | -60.56 | 19.10 |
| -59.75 | 38.00 | | -59.75 | 62.00 | | -59.75 | 19.01 |
| -58.95 | 38.00 | | -58.95 | 62.00 | | -58.95 | 18.92 |
| -58.15 | 38.00 | | -58.15 | 62.00 | | -58.15 | 18.82 |
| -57.35 | 38.00 | | -57.35 | 62.00 | | -57.35 | 18.71 |
| -56.55 | 38.00 | | -56.55 | 62.00 | | -56.55 | 18.61 |
| -55.75 | 38.00 | | -55.75 | 62.00 | | -55.75 | 18.49 |
| -54.94 | 38.00 | | -54.94 | 62.00 | | -54.94 | 18.38 |
| -54.14 | 38.00 | | -54.14 | 62.00 | | -54.14 | 18.26 |
| -53.34 | 38.00 | | -53.34 | 62.00 | | -53.34 | 18.13 |
| -52.54 | 38.00 | | -52.54 | 62.00 | | -52.54 | 18.01 |
| -51.74 | 38.00 | | -51.74 | 62.00 | | -51.74 | 17.87 |
| -50.94 | 38.00 | | -50.94 | 62.00 | | -50.94 | 17.73 |
| -50.13 | 38.00 | | -50.13 | 62.00 | | -50.13 | 17.60 |
| -49.33 | 38.00 | | -49.33 | 62.00 | | -49.33 | 17.46 |
| -48.53 | 38.00 | | -48.53 | 62.00 | | -48.53 | 17.32 |
| -47.73 | 38.00 | | -47.73 | 62.00 | | -47.73 | 17.18 |

(fortgesetzt)

| Sekundärdüse Außenkontur | | | Skundärdüse Innenkontur | | | Primärdüse Innenkontur | |
|---|---|---|---|---|---|---|---|
| x in mm | r in mm | | x in mm | r in mm | | x in mm | r in mm |
| -46.93 | 38.00 | | -46.93 | 62.00 | | -46.93 | 17.05 |
| -46.13 | 38.00 | | -46.13 | 62.00 | | -46.13 | 16.91 |
| -45.33 | 38.00 | | -45.33 | 62.00 | | -45.33 | 16.77 |
| -44.52 | 38.00 | | -44.52 | 62.00 | | -44.52 | 16.63 |
| -43.72 | 38.00 | | -43.72 | 62.00 | | -43.72 | 16.49 |
| -42.92 | 38.00 | | -42.92 | 62.00 | | -42.92 | 16.35 |
| -42.12 | 38.00 | | -42.12 | 62.00 | | -42.12 | 16.22 |
| -41.32 | 38.00 | | -41.32 | 62.00 | | -41.32 | 16.08 |
| -40.52 | 38.00 | | -40.52 | 62.00 | | -40.52 | 15.95 |
| -39.71 | 38.00 | | -39.71 | 62.00 | | -39.71 | 15.82 |
| -38.91 | 38.00 | | -38.91 | 62.00 | | -38.91 | 15.70 |
| -38.11 | 38.00 | | -38.11 | 62.00 | | -38.11 | 15.57 |
| -37.31 | 38.00 | | -37.31 | 62.00 | | -37.31 | 15.45 |
| -36.51 | 38.00 | | -36.51 | 62.00 | | -36.51 | 15.33 |
| -35.71 | 38.00 | | -35.71 | 62.00 | | -35.71 | 15.22 |
| -34.90 | 38.00 | | -34.90 | 62.00 | | -34.90 | 15.10 |
| -34.10 | 38.00 | | -34.10 | 62.00 | | -34.10 | 14.99 |
| -33.30 | 38.00 | | -33.30 | 62.00 | | -33.30 | 14.89 |
| -32.50 | 38.00 | | -32.50 | 62.00 | | -32.50 | 14.78 |
| -31.70 | 38.00 | | -31.70 | 62.00 | | -31.70 | 14.68 |
| -30.90 | 38.00 | | -30.90 | 62.00 | | -30.90 | 14.58 |
| -30.10 | 38.00 | | -30.10 | 62.00 | | -30.10 | 14.48 |
| -29.29 | 38.00 | | -29.29 | 62.00 | | -29.29 | 14.39 |
| -28.49 | 38.00 | | -28.49 | 62.00 | | -28.49 | 14.30 |
| -27.69 | 38.00 | | -27.69 | 62.00 | | -27.69 | 14.21 |
| -26.89 | 38.00 | | -26.89 | 62.00 | | -26.89 | 14.12 |
| -26.09 | 38.00 | | -26.09 | 62.00 | | -26.09 | 14.04 |
| -25.29 | 38.00 | | -25.29 | 62.00 | | -25.29 | 13.96 |
| -24.48 | 38.00 | | -24.48 | 62.00 | | -24.48 | 13.88 |
| -23.68 | 38.00 | | -23.68 | 62.00 | | -23.68 | 13.80 |
| -22.88 | 38.00 | | -22.88 | 62.00 | | -22.88 | 13.73 |
| -22.08 | 38.00 | | -22.08 | 62.00 | | -22.08 | 13.66 |
| -21.28 | 38.00 | | -21.28 | 62.00 | | -21.28 | 13.59 |
| -20.48 | 38.00 | | -20.48 | 62.00 | | -20.48 | 13.52 |
| -19.67 | 38.00 | | -19.67 | 62.00 | | -19.67 | 13.46 |
| -18.87 | 38.00 | | -18.87 | 62.00 | | -18.87 | 13.40 |
| -18.07 | 38.00 | | -18.07 | 62.00 | | -18.07 | 13.34 |

(fortgesetzt)

| Sekundärdüse Außenkontur | | | Skundärdüse Innenkontur | | | Primärdüse Innenkontur | |
|---|---|---|---|---|---|---|---|
| x in mm | r in mm | | x in mm | r in mm | | x in mm | r in mm |
| -17.27 | 38.00 | | -17.27 | 62.00 | | -17.27 | 13.29 |
| -16.47 | 38.00 | | -16.47 | 62.00 | | -16.47 | 13.24 |
| -15.67 | 38.00 | | -15.67 | 62.00 | | -15.67 | 13.19 |
| -14.87 | 38.00 | | -14.87 | 62.00 | | -14.87 | 13.14 |
| -14.06 | 38.00 | | -14.06 | 62.00 | | -14.06 | 13.10 |
| -13.26 | 38.00 | | -13.26 | 62.00 | | -13.26 | 13.05 |
| -12.46 | 38.00 | | -12.46 | 62.00 | | -12.46 | 13.02 |
| -11.66 | 38.00 | | -11.66 | 62.00 | | -11.66 | 12.98 |
| -10.86 | 38.00 | | -10.86 | 62.00 | | -10.86 | 12.95 |
| -10.06 | 38.00 | | -10.06 | 62.00 | | -10.06 | 12.91 |
| -9.25 | 38.00 | | -9.25 | 62.00 | | -9.25 | 12.89 |
| -8.45 | 38.00 | | -8.45 | 62.00 | | -8.45 | 12.86 |
| -7.65 | 38.00 | | -7.65 | 62.00 | | -7.65 | 12.84 |
| -6.85 | 38.00 | | -6.85 | 62.00 | | -6.85 | 12.82 |
| -6.05 | 38.00 | | -6.05 | 62.00 | | -6.05 | 12.80 |
| -5.25 | 38.00 | | -5.25 | 62.00 | | -5.25 | 12.78 |
| -4.44 | 38.00 | | -4.44 | 62.00 | | -4.44 | 12.77 |
| -3.64 | 38.00 | | -3.64 | 62.00 | | -3.64 | 12.76 |
| -2.84 | 38.00 | | -2.84 | 62.00 | | -2.84 | 12.75 |
| -2.04 | 38.00 | | -2.04 | 62.00 | | -2.04 | 12.75 |
| -1.24 | 38.00 | | -1.24 | 62.00 | | -1.24 | 12.74 |
| -0.44 | 38.00 | | -0.44 | 62.00 | | -0.44 | 12.74 |
| 0.36 | 38.00 | | 0.36 | 62.00 | | 0.36 | 12.75 |
| 1.17 | 38.00 | | 1.17 | 62.00 | | 1.17 | 12.75 |
| 1.97 | 38.00 | | 1.97 | 62.00 | | 1.97 | 12.76 |
| 2.77 | 38.00 | | 2.77 | 62.00 | | 2.77 | 12.77 |
| 3.57 | 38.00 | | 3.57 | 62.00 | | 3.57 | 12.79 |
| 4.37 | 38.00 | | 4.37 | 62.00 | | 4.37 | 12.80 |
| 5.17 | 38.00 | | 5.17 | 62.00 | | 5.17 | 12.82 |
| 5.98 | 38.00 | | 5.98 | 62.00 | | 5.98 | 12.85 |
| 6.78 | 38.00 | | 6.78 | 62.00 | | 6.78 | 12.87 |
| 7.58 | 38.00 | | 7.58 | 62.00 | | 7.58 | 12.90 |
| 8.38 | 38.00 | | 8.38 | 62.00 | | 8.38 | 12.93 |
| 9.18 | 38.00 | | 9.18 | 62.00 | | 9.18 | 12.96 |
| 9.98 | 38.00 | | 9.98 | 62.00 | | 9.98 | 13.00 |
| 10.79 | 38.00 | | 10.79 | 62.00 | | 10.79 | 13.03 |
| 11.59 | 38.00 | | 11.59 | 62.00 | | 11.59 | 13.08 |
| Sekundärdüse Außenkontur | | | Skundärdüse Innenkontur | | | Primärdüse Innenkontur | |

(fortgesetzt)

| Sekundärdüse Außenkontur | | | Skundärdüse Innenkontur | | | Primärdüse Innenkontur | |
|---|---|---|---|---|---|---|---|
| x in mm | r in mm | | x in mm | r in mm | | x in mm | r in mm |
| 12.39 | 38.00 | | 12.39 | 62.00 | | 12.39 | 13.12 |
| 13.19 | 38.00 | | 13.19 | 62.00 | | 13.19 | 13.17 |
| 13.99 | 38.00 | | 13.99 | 62.00 | | 13.99 | 13.21 |
| 14.79 | 38.00 | | 14.79 | 62.00 | | 14.79 | 13.27 |
| 15.59 | 38.00 | | 15.59 | 62.00 | | 15.59 | 13.32 |
| 16.40 | 38.00 | | 16.40 | 62.00 | | 16.40 | 13.38 |
| 17.20 | 38.00 | | 17.20 | 62.00 | | 17.20 | 13.44 |
| 18.00 | 38.00 | | 18.00 | 62.00 | | 18.00 | 13.50 |
| 18.80 | 38.00 | | 18.80 | 62.00 | | 18.80 | 13.56 |
| 19.60 | 38.00 | | 19.60 | 62.00 | | 19.60 | 13.63 |
| 20.40 | 38.00 | | 20.40 | 62.00 | | 20.40 | 13.70 |
| 21.21 | 38.00 | | 21.21 | 61.98 | | 21.21 | 13.78 |
| 22.01 | 38.00 | | 22.01 | 61.96 | | 22.01 | 13.85 |
| 22.81 | 38.00 | | 22.81 | 61.92 | | 22.81 | 13.93 |
| 23.61 | 38.00 | | 23.61 | 61.86 | | 23.61 | 14.01 |
| 24.41 | 38.00 | | 24.41 | 61.80 | | 24.41 | 14.10 |
| 25.21 | 38.00 | | 25.21 | 61.72 | | 25.21 | 14.18 |
| 26.02 | 38.00 | | 26.02 | 61.63 | | 26.02 | 14.27 |
| 26.82 | 38.00 | | 26.82 | 61.52 | | 26.82 | 14.37 |
| 27.62 | 38.00 | | 27.62 | 61.40 | | 27.62 | 14.46 |
| 28.42 | 38.00 | | 28.42 | 61.27 | | 28.42 | 14.56 |
| 29.22 | 38.00 | | 29.22 | 61.13 | | 29.22 | 14.65 |
| 30.02 | 38.00 | | 30.02 | 60.97 | | 30.02 | 14.75 |
| 30.82 | 38.00 | | 30.82 | 60.80 | | 30.82 | 14.84 |
| 31.63 | 38.00 | | 31.63 | 60.61 | | 31.63 | 14.94 |
| 32.43 | 38.00 | | 32.43 | 60.41 | | 32.43 | 15.04 |
| 33.23 | 38.00 | | 33.23 | 60.20 | | 33.23 | 15.13 |
| 34.03 | 38.00 | | 34.03 | 59.97 | | 34.03 | 15.22 |
| 34.83 | 38.00 | | 34.83 | 59.73 | | 34.83 | 15.32 |
| 35.63 | 38.00 | | 35.63 | 59.47 | | 35.63 | 15.41 |
| 36.44 | 37.99 | | 36.44 | 59.20 | | 36.44 | 15.50 |
| 37.24 | 37.96 | | 37.24 | 58.91 | | 37.24 | 15.59 |
| 38.04 | 37.92 | | 38.04 | 58.60 | | 38.04 | 15.68 |
| 38.84 | 37.86 | | 38.84 | 58.28 | | 38.84 | 15.76 |
| 39.64 | 37.78 | | 39.64 | 57.95 | | 39.64 | 15.85 |
| 40.44 | 37.69 | | 40.44 | 57.60 | | 40.44 | 15.93 |
| 41.25 | 37.58 | | 41.25 | 57.23 | | 41.25 | 16.02 |

(fortgesetzt)

| Sekundärdüse Außenkontur | | | Skundärdüse Innenkontur | | | Primärdüse Innenkontur | |
|---|---|---|---|---|---|---|---|
| x in mm | r in mm | | x in mm | r in mm | | x in mm | r in mm |
| 42.05 | 37.45 | | 42.05 | 56.84 | | 42.05 | 16.10 |
| 42.85 | 37.31 | | 42.85 | 56.44 | | 42.85 | 16.18 |
| 43.65 | 37.15 | | 43.65 | 56.01 | | 43.65 | 16.26 |
| 44.45 | 36.97 | | 44.45 | 55.57 | | 44.45 | 16.33 |
| 45.25 | 36.78 | | 45.25 | 55.11 | | 45.25 | 16.41 |
| 46.05 | 36.57 | | 46.05 | 54.63 | | 46.05 | 16.48 |
| 46.86 | 36.34 | | 46.86 | 54.13 | | 46.86 | 16.55 |
| 47.66 | 36.09 | | 47.66 | 53.60 | | 47.66 | 16.62 |
| 48.46 | 35.83 | | 48.46 | 53.06 | | 48.46 | 16.69 |
| 49.26 | 35.54 | | 49.26 | 52.49 | | 49.26 | 16.76 |
| 50.06 | 35.24 | | 50.06 | 51.90 | | 50.06 | 16.82 |
| 50.86 | 34.91 | | 50.86 | 51.28 | | 50.86 | 16.88 |
| 51.67 | 34.57 | | 51.67 | 50.63 | | 51.67 | 16.94 |
| 52.47 | 34.20 | | 52.47 | 49.96 | | 52.47 | 17.00 |
| 53.27 | 33.81 | | 53.27 | 49.26 | | 53.27 | 17.06 |
| 54.07 | 33.40 | | 54.07 | 48.53 | | 54.07 | 17.12 |
| 54.87 | 32.97 | | 54.87 | 47.76 | | 54.87 | 17.17 |
| 55.67 | 32.51 | | 55.67 | 46.96 | | 55.67 | 17.23 |
| 56.48 | 32.05 | | 56.48 | 46.16 | | 56.48 | 17.28 |
| 57.28 | 31.59 | | 57.28 | 45.36 | | 57.28 | 17.33 |
| 58.08 | 31.13 | | 58.08 | 44.56 | | 58.08 | 17.37 |
| 58.88 | 30.66 | | 58.88 | 43.76 | | 58.88 | 17.42 |
| 59.68 | 30.20 | | 59.68 | 42.96 | | 59.68 | 17.46 |
| 60.48 | 29.74 | | 60.48 | 42.15 | | 60.48 | 17.51 |
| 61.28 | 29.29 | | 61.28 | 41.35 | | 61.28 | 17.55 |
| 62.09 | 28.86 | | 62.09 | 40.55 | | 62.09 | 17.59 |
| 62.89 | 28.45 | | 62.89 | 39.75 | | 62.89 | 17.62 |
| 63.69 | 28.05 | | 63.69 | 38.95 | | 63.69 | 17.66 |
| 64.49 | 27.68 | | 64.49 | 38.15 | | 64.49 | 17.70 |
| 65.29 | 27.32 | | 65.29 | 37.41 | | 65.29 | 17.73 |
| 66.09 | 26.97 | | 66.09 | 36.71 | | 66.09 | 17.76 |
| 66.90 | 26.65 | | 66.90 | 36.06 | | 66.90 | 17.79 |
| 67.70 | 26.34 | | 67.70 | 35.46 | | 67.70 | 17.82 |
| 68.50 | 26.04 | | 68.50 | 34.90 | | 68.50 | 17.85 |
| 69.30 | 25.77 | | 69.30 | 34.37 | | 69.30 | 17.87 |
| 70.10 | 25.50 | | 70.10 | 33.88 | | 70.10 | 17.89 |
| 70.90 | 25.25 | | 70.90 | 33.43 | | 70.90 | 17.92 |

(fortgesetzt)

| Sekundärdüse Außenkontur | | | Skundärdüse Innenkontur | | | Primärdüse Innenkontur | |
|---|---|---|---|---|---|---|---|
| x in mm | r in mm | | x in mm | r in mm | | x in mm | r in mm |
| 71.71 | 25.02 | | 71.71 | 33.00 | | 71.71 | 17.94 |
| 72.51 | 24.80 | | 72.51 | 32.61 | | 72.51 | 17.96 |
| 73.31 | 24.59 | | 73.31 | 32.25 | | 73.31 | 17.98 |
| 74.11 | 24.40 | | 74.11 | 31.91 | | 74.11 | 18.00 |
| 74.91 | 24.22 | | 74.91 | 31.60 | | 74.91 | 18.01 |
| 75.71 | 24.06 | | 75.71 | 31.32 | | 75.71 | 18.03 |
| 76.51 | 23.91 | | 76.51 | 31.06 | | 76.51 | 18.04 |
| 77.32 | 23.77 | | 77.32 | 30.82 | | 77.32 | 18.05 |
| 78.12 | 23.65 | | 78.12 | 30.61 | | 78.12 | 18.06 |
| 78.92 | 23.54 | | 78.92 | 30.42 | | 78.92 | 18.07 |
| 79.72 | 23.44 | | 79.72 | 30.26 | | 79.72 | 18.08 |
| 80.52 | 23.36 | | 80.52 | 30.12 | | 80.52 | 18.09 |
| 81.32 | 23.29 | | 81.32 | 30.00 | | 81.32 | 18.10 |
| 82.13 | 23.23 | | 82.13 | 29.90 | | 82.13 | 18.11 |
| 82.93 | 23.18 | | 82.93 | 29.83 | | 82.93 | 18.11 |
| 83.73 | 23.15 | | 83.73 | 29.77 | | 83.73 | 18.12 |
| 84.53 | 23.13 | | 84.53 | 29.74 | | 84.53 | 18.12 |
| 85.33 | 23.13 | | 85.33 | 29.73 | | 85.33 | 18.13 |

**15.** Injektor gemäß Anspruch 14, dass die Innenkontur der Primärdüse der auf numerischem Wege mit einem modifizierten Charakteristikenverfahren ermittelten Kontur entspricht.

**Claims**

**1.** Injector for use in metallurgical plants, particularly in a basic oxygen furnace (BOF), in an argon oxygen decarburisation (AOD) converter or in an electric arc furnace (EAF), with a primary nozzle, which is designed as a supersonic nozzle, for blowing an oxygen-rich gas onto a metal melt and a secondary nozzle, which is arranged coaxially with respect to the primary nozzle, for producing a coaxial jet surrounding the gas jet issuing from the primary nozzle, wherein the primary nozzle has a convergent section and a divergent section which adjoin one another at a radius of the narrowest cross-section r* and wherein for the primary nozzle the ratio of a nozzle length l to the radius at the narrowest cross-section r*, thus l/r*, lies between 2.1 and 11.6, preferably between 2.1 and 8.3, more preferably between 2.1 and 5.4, even more preferably between 2.1 and 5.0, and has, in particular, a value of 11.6, 8.3, 5.4, 5.0, 4.8, 4.2, 4.1, 3.6, 3.3, 3.1 or 2.1, **characterised in that** the primary nozzle and the secondary nozzle are defined by the following family of nozzle shapes in the respective nozzle case thereof:

| Primary nozzle | | | | | Secondary nozzle | | |
|---|---|---|---|---|---|---|---|
| Pressure $p_0$ [bar] | Volume flow $\dot{V}_0$ [Nm$^3$/min] | Radius at the narrowest cross-section r* [mm] | Outlet radius $r_1$ [mm] | Nozzle length l [mm] | Mach number $M_s$ [-] | Temperature $T_s$ [K] | Coaxial gap height $H_s$ [mm] |
| 4 | 20 | 12.0 | 14.0 | 50 $\pm$ 20 | 0.5 $\pm$ 0.2 | 1000 $\pm$ 200 | 7 $\pm$ 3 |

(continued)

| Primary nozzle | | | | | Secondary nozzle | | |
|---|---|---|---|---|---|---|---|
| Pressure $p_0$ [bar] | Volume flow $\dot{V}_0$ [Nm³/min] | Radius at the narrowest cross-section r* [mm] | Outlet radius $r_1$ [mm] | Nozzle length l [mm] | Mach number $M_s$ [-] | Temperature $T_s$ [K] | Coaxial gap height $H_s$ [mm] |
| 4 | 200 | 39 | 44.0 | 160 ± 20 | 0.5 ± 0.2 | 1000 ± 200 | 7 ± 3 |
| 14 | 20 | 6 | 10.0 | 50 ± 20 | 0.5 ± 0.2 | 1000 ± 200 | 7 ± 3 |
| 14 | 200 | 21 | 33.0 | 160 ± 20 | 0.5 ± 0.2 | 1000 ± 200 | 7 ± 3 |

2. Injector for use in metallurgical plants, particularly in a basic oxygen furnace (BOF), in an argon oxygen decarburisation (AOD) converter or in an electric arc furnace (EAF), with a primary nozzle, which is designed as a supersonic nozzle, for blowing an oxygen-rich gas onto a metal melt and a secondary nozzle, which is arranged coaxially with respect to the primary nozzle, for producing a coaxial jet surrounding the gas jet issuing from the primary nozzle, wherein the primary nozzle has a convergent section and a divergent section which adjoin one another at a radius of the narrowest cross-section r*, **characterised in that** the inner contour and the outer contour of the secondary nozzle are numerically determined in such a way that the convective Mach number $M_{c\infty s}$ between the environment ($\infty$) and the secondary jet (s) produced by the secondary nozzle is equal to the convective Mach number $M_{csp}$ between the secondary jet (s) and the primary jet (p) produced by the primary nozzle:

$$M_{c\infty s} = M_{csp} \, ,$$

wherein the numerical determination comprises the steps:

a) determination of the convective Mach numbers:

single jet: $M_{c\infty p}$ between environment and primary jet

$$M_{c\infty p} = \frac{M_p \sqrt{\rho_\infty / \rho_p}}{\left(1 + \sqrt{\rho_\infty / \rho_p}\right)\left(\gamma_\infty / \gamma_p\right)^{1/4}}$$

coaxial jet: $M_{c\infty s}$ between environment and secondary jet and $M_{csp}$ between secondary jet and primary jet

$$M_{c\infty s} = \frac{M_s \sqrt{\rho_\infty / \rho_s}}{\left(1 + \sqrt{\rho_\infty / \rho_s}\right)\left(\gamma_\infty / \gamma_s\right)^{1/4}} \, , \qquad M_{csp} = \frac{M_p \sqrt{\rho_s / \rho_p}\left(1 - u_s / u_p\right)}{\left(1 + \sqrt{\rho_s / \rho_p}\right)\left(\gamma_s / \gamma_p\right)^{1/4}}$$

b) determination of the optimum operating parameter for the coaxial jet, applicable to cold primary jet, hot secondary jet and hot environment:

new optimisation criterion:

**new optimisation criterion:** $M_{c\infty s} = M_{csp}$

Mach number of the secondary jet:

$$M_s = \frac{u_s}{a_s} = \frac{u_p}{a_s}\left[1 + \frac{a_p}{a_s}\left(\frac{1+\sqrt{\rho_p/\rho_s}}{1+\sqrt{\rho_s/\rho_\infty}}\right)\left(\frac{\gamma_p\gamma_\infty}{\gamma_s^2}\right)^{-1/4}\right]^{-1},$$

c) determination of the new correlation model for the coaxial jet, applicable to cold primary jet, hot secondary jet and hot environment: functions of the convective Mach number:

$$F_{\infty p} = M_{c\infty p}^2, \quad F_{sp} = M_{csp}^2, \quad F_{\infty s} = M_{c\infty s}^2,$$

switching and geometric functions:

$$F_{\infty sp} = \alpha\left(\frac{F_{sp}F_{\infty s}}{\beta F_{sp} + F_{\infty s}}\right), \qquad F_p = 1 + \frac{F_{\infty sp}}{F_{sp}F_{\infty p}}\left(F_{sp} - F_{\infty p}\right), \quad F_h = 1 + \sigma\left(H_s/D_p\right),$$

function of the jet length:

$$\frac{L_p^*}{L_{single}^*} = \varphi F_h \cdot \exp\left[-\theta \cdot abs\left(F_p\right)\right].$$

3. Injector according to claim 1 or 2, **characterised in that** the primary nozzle is intended for use with oxygen and the secondary nozzle for use with $CH_4$ or LPG.

4. Injector according to any one of the preceding claims, **characterised in that** the secondary nozzle is designed as an subsonic nozzle.

5. Injector according to any one of the preceding claims, **characterised in that** a hot gas generator coupled with the secondary nozzle is provided, which provides a secondary jet of hot combustion gas by way of the secondary nozzle.

6. Injector according to claim 5, **characterised in that** the hot gas generator is so controllable that the quantity, which is optimised for design of the secondary nozzle and the primary nozzle, of waste gas is reached at an optimised waste gas temperature.

7. Injector according to any one of the preceding claims, **characterised in that** the inner contour of the primary nozzle corresponds with the contour determined on a numerical path by a modified characteristic method.

8. Injector according to any one of the preceding claims, **characterised in that** the inner contour of the primary nozzle corresponds with the determined contour which is determined by numerical solution of the partial gas-dynamic differential equations, in which the static, isentropic, rotationally symmetrical gas flow is represented by means of spatially discretised characteristic equations with consideration of appropriate compatibility conditions.

9. Injector according to claim 8, **characterised in that** the influence of a boundary layer flow subject to friction and close to the wall is taken into consideration in the solution of the partial numerical differential equations.

10. Injector according to any one of the preceding claims, **characterised in that** in the primary nozzle the convergent section has a bell-shaped contour and the divergent section has a bell-shaped contour, wherein the bell-shaped contours of the convergent section and of the divergent section progressively merge into one another at the nozzle throat.

11. Injector according to any one of the preceding claims, **characterised in that** the primary nozzle has a convergent subsonic part and a divergent supersonic part and the inner contour corresponds with a contour determined by a modified characteristic method which produces a lengthy supersonic region $L^*_p$, and the secondary nozzle starting therefrom has an inner contour and an outer contour in a form which on a numerical path includes not only the entire geometry, but also the thermal process variables of the coaxial gas in such a way that the supersonic length $\mathsf{L}^*_p$ of the primary jet is further lengthened.

12. Injector according to any one of the preceding claims, **characterised in that** it is operable in an injector mode and a burner mode, wherein in the injector mode an oxygen-rich primary jet shrouded by a secondary jet coaxial therewith can be applied to a metal melt and in the burner mode $CH_4$ or LPG can be so fed by way of the secondary nozzle and an oxygen-rich gas by way of the primary nozzle that a focal jet is produced.

13. Injector according to claim 12, **characterised by** the following operating parameters in the injector mode and the burner mode:

| Injector mode: | oxygen entry pressure at primary nozzle: | $p_0$ = 10 bars |
| | oxygen volume flow at primary nozzle: | $\dot{v}_0$ = 50 Nm$^3$/min |
| | environment pressure: | $p_\infty$ = 1.013 bars |
| Burner mode: | burner output: | P = 6.00 MW |

| Injector mode | | | | | | Burner mode | | | | | |
|---|---|---|---|---|---|---|---|---|---|---|---|
| Primary jet | | | Secondary jet | | | Primary jet | | | Secondary jet | | |
| $M_p$ | - | 2.149 | $M_s$ | - | 0.482 | P | MW | 6.00 | | | |
| $T_p$ | K | 152.9 | $T_s$ | K | 1100.0 | $\dot{v}_{p,O2}$ | Nm$^3$/h | 1205.6 | $\dot{v}_{s,CH4}$ | NM$_3$/h | 01.9 |
| $\dot{v}_p$ | Nm$^3$/h | 3000 | $H_s$ | m | 0.0066 4 | $\dot{m}_{p,O2}$ | kg/s | 0.4786 | $\dot{m}_{p,CH4}$ | kg/s | 0.1200 |
| $u_p$ | m/s | 506.2 | $\dot{v}_s$ | Nm$^3$/h | 311.0 | | | | | | |
| $p_p$ | Pa | 101325 | $\dot{v}_{s,CH4}$ | Nm$^3$/h | 11.0 | | | | | | |
| | | | $\dot{v}_{s,air}$ | Nm$^3$/h | 300 | | | | | | |
| | | | $T_{0,s}$ | K | 1144.7 | | | | | | |
| | | | $u_s$ | m/s | 317.8 | | | | | | |
| | | | $p_s$ | Pa | 101325 | | | | | | |
| | | | $\dot{m}_s$ | kg/s | 0.1099 | | | | | | |
| | | | $\dot{m}_{s,CH4}$ | kg/s | 0.0022 | | | | | | |
| | | | $\dot{m}_{s,air}$ | kg/s | 0.1077 | | | | | | |
| | | | $p_{0,s}$ | Pa | 118162 | | | | | | |
| Supersonic length: $L^*_{p,single}$ = 1.107m, $L^*_{p,coaxial}$ = 1.608 m | | | | | | | | | | | |

14. Injector for use in metallurgical plants, particularly in a basic oxygen furnace (BOF), in an argon oxygen decarburisation (AOD) converter or in an electric arc furnace (EAF), with a primary nozzle, which is designed as a supersonic nozzle, for blowing an oxygen-rich gas onto a metal melt and a secondary nozzle, which is arranged coaxially with respect to the primary nozzle, for producing a coaxial jet surrounding the gas jet issuing from the primary nozzle, wherein the primary nozzle has a convergent section and a divergent section which adjoin one another at a radius of the narrowest cross-section r*, **characterised by** the following dimensions in the following design case for axial co-ordinates (x) and radial co-ordinates (r):

| Injector | | | | | | | |
|---|---|---|---|---|---|---|---|
| Oxygen entry pressure primary nozzle: $p_0$ = 10 bar | | | | | | | |
| Oxygen volume flow primary nozzle: $\dot{v}_0$ = 50 $_{Nm}$3/min | | | | | | | |
| Environmental pressure: $p_\infty$ = 1.013 bar | | | | | | | |
| Burner performance: P = 6.00 MW | | | | | | | |
| Secondary nozzle outer contour | | | Secondary nozzle inner contour | | | Primary nozzle inner contour | |
| x in mm | r in mm | | x in mm | r in mm | | x in mm | r in mm |
| -77.39 | 38.00 | | -77.39 | 62.00 | | -77.39 | 20.02 |
| -76.59 | 38.00 | | -76.59 | 62.00 | | -76.59 | 20.03 |
| -75.79 | 38.00 | | -75.79 | 62.00 | | -75.79 | 20.03 |
| -74.98 | 38.00 | | -74.98 | 62.00 | | -74.98 | 20.02 |
| -74.18 | 38.00 | | -74.18 | 62.00 | | -74.18 | 20.00 |
| -73.38 | 38.00 | | -73.38 | 62.00 | | -73.38 | 19.99 |
| -72.58 | 38.00 | | -72.58 | 62.00 | | -72.58 | 19.96 |
| -71.78 | 38.00 | | -71.78 | 62.00 | | -71.78 | 19.93 |
| -70.98 | 38.00 | | -70.98 | 62.00 | | -70.98 | 19.90 |
| -70.17 | 38.00 | | -70.17 | 62.00 | | -70.17 | 19.87 |
| -69.37 | 38.00 | | -69.37 | 62.00 | | -69.37 | 19.83 |
| -68.57 | 38.00 | | -68.57 | 62.00 | | -68.57 | 19.78 |
| -67.77 | 38.00 | | -67.77 | 62.00 | | -67.77 | 19.73 |
| -66.97 | 38.00 | | -66.97 | 62.00 | | -66.97 | 19.68 |
| -66.17 | 38.00 | | -66.17 | 62.00 | | -66.17 | 19.62 |
| -65.36 | 38.00 | | -65.36 | 62.00 | | -65.36 | 19.56 |
| -64.56 | 38.00 | | -64.56 | 62.00 | | -64.56 | 19.49 |
| -63.76 | 38.00 | | -63.76 | 62.00 | | -63.76 | 19.42 |
| -62.96 | 38.00 | | -62.96 | 62.00 | | -62.96 | 19.35 |
| -62.16 | 38.00 | | -62.16 | 62.00 | | -62.16 | 19.27 |
| -61.36 | 38.00 | | -61.36 | 62.00 | | -61.36 | 19.19 |
| -60.56 | 38.00 | | -60.56 | 62.00 | | -60.56 | 19.10 |
| -59.75 | 38.00 | | -59.75 | 62.00 | | -59.75 | 19.01 |
| -58.95 | 38.00 | | -58.95 | 62.00 | | -58.95 | 18.92 |
| -58.15 | 38.00 | | -58.15 | 62.00 | | -58.15 | 18.82 |
| -57.35 | 38.00 | | -57.35 | 62.00 | | -57.35 | 18.71 |
| -56.55 | 38.00 | | -56.55 | 62.00 | | -56.55 | 18.61 |
| -55.75 | 38.00 | | -55.75 | 62.00 | | -55.75 | 18.49 |
| -54.94 | 38.00 | | -54.94 | 62.00 | | -54.94 | 18.38 |
| -54.14 | 38.00 | | -54.14 | 62.00 | | -54.14 | 18.26 |
| -53.34 | 38.00 | | -53.34 | 62.00 | | -53.34 | 18.13 |
| -52.54 | 38.00 | | -52.54 | 62.00 | | -52.54 | 18.01 |

(continued)

| Secondary nozzle outer contour | | | Secondary nozzle inner contour | | | Primary nozzle inner contour | |
|---|---|---|---|---|---|---|---|
| -51.74 | 38.00 | | -51.74 | 62.00 | | -51.74 | 17.87 |
| -50.94 | 38.00 | | -50.94 | 62.00 | | -50.94 | 17.73 |
| -50.13 | 38.00 | | -50.13 | 62.00 | | -50.13 | 17.60 |
| -49.33 | 38.00 | | -49.33 | 62.00 | | -49.33 | 17.46 |
| -48.53 | 38.00 | | -48.53 | 62.00 | | -48.53 | 17.32 |
| -47.73 | 38.00 | | -47.73 | 62.00 | | -47.73 | 17.18 |
| -46.93 | 38.00 | | -46.93 | 62.00 | | -46.93 | 17.05 |
| -46.13 | 38.00 | | -46.13 | 62.00 | | -46.13 | 16.91 |
| -45.33 | 38.00 | | -45.33 | 62.00 | | -45.33 | 16.77 |
| -44.52 | 38.00 | | -44.52 | 62.00 | | -44.52 | 16.63 |
| -43.72 | 38.00 | | -43.72 | 62.00 | | -43.72 | 16.49 |
| -42.92 | 38.00 | | -42.92 | 62.00 | | -42.92 | 16.35 |
| -42.12 | 38.00 | | -42.12 | 62.00 | | -42.12 | 16.22 |
| -41.32 | 38.00 | | -41.32 | 62.00 | | -41.32 | 16.08 |
| -40.52 | 38.00 | | -40.52 | 62.00 | | -40.52 | 15.95 |
| -39.71 | 38.00 | | -39.71 | 62.00 | | -39.71 | 15.82 |
| -38.91 | 38.00 | | -38.91 | 62.00 | | -38.91 | 15.70 |
| -38.11 | 38.00 | | -38.11 | 62.00 | | -38.11 | 15.57 |
| -37.31 | 38.00 | | -37.31 | 62.00 | | -37.31 | 15.45 |
| -36.51 | 38.00 | | -36.51 | 62.00 | | -36.51 | 15.33 |
| -35.71 | 38.00 | | -35.71 | 62.00 | | -35.71 | 15.22 |
| -34.90 | 38.00 | | -34.90 | 62.00 | | -34.90 | 15.10 |
| -34.10 | 38.00 | | -34.10 | 62.00 | | -34.10 | 14.99 |
| -33.30 | 38.00 | | -33.30 | 62.00 | | -33.30 | 14.89 |
| -32.50 | 38.00 | | -32.50 | 62.00 | | -32.50 | 14.78 |
| -31.70 | 38.00 | | -31.70 | 62.00 | | -31.70 | 14.68 |
| -30.90 | 38.00 | | -30.90 | 62.00 | | -30.90 | 14.58 |
| -30.10 | 38.00 | | -30.10 | 62.00 | | -30.10 | 14.48 |
| -29.29 | 38.00 | | -29.29 | 62.00 | | -29.29 | 14.39 |
| -28.49 | 38.00 | | -28.49 | 62.00 | | -28.49 | 14.30 |
| -27.69 | 38.00 | | -27.69 | 62.00 | | -27.69 | 14.21 |
| -26.89 | 38.00 | | -26.89 | 62.00 | | -26.89 | 14.12 |
| -26.09 | 38.00 | | -26.09 | 62.00 | | -26.09 | 14.04 |
| -25.29 | 38.00 | | -25.29 | 62.00 | | -25.29 | 13.96 |
| -24.48 | 38.00 | | -24.48 | 62.00 | | -24.48 | 13.88 |
| -23.68 | 38.00 | | -23.68 | 62.00 | | -23.68 | 13.80 |
| -22.88 | 38.00 | | -22.88 | 62.00 | | -22.88 | 13.73 |
| -22.08 | 38.00 | | -22.08 | 62.00 | | -22.08 | 13.66 |

(continued)

| Secondary nozzle outer contour | | | Secondary nozzle inner contour | | | Primary nozzle inner contour | |
|---|---|---|---|---|---|---|---|
| -21.28 | 38.00 | | -21.28 | 62.00 | | -21.28 | 13.59 |
| -20.48 | 38.00 | | -20.48 | 62.00 | | -20.48 | 13.52 |
| -19.67 | 38.00 | | -19.67 | 62.00 | | -19.67 | 13.46 |
| -18.87 | 38.00 | | -18.87 | 62.00 | | -18.87 | 13.40 |
| -18.07 | 38.00 | | -18.07 | 62.00 | | -18.07 | 13.34 |
| -17.27 | 38.00 | | -17.27 | 62.00 | | -17.27 | 13.29 |
| -16.47 | 38.00 | | -16.47 | 62.00 | | -16.47 | 13.24 |
| -15.67 | 38.00 | | -15.67 | 62.00 | | -15.67 | 13.19 |
| -14.87 | 38.00 | | -14.87 | 62.00 | | -14.87 | 13.14 |
| -14.06 | 38.00 | | -14.06 | 62.00 | | -14.06 | 13.10 |
| -13.26 | 38.00 | | -13.26 | 62.00 | | -13.26 | 13.05 |
| -12.46 | 38.00 | | -12.46 | 62.00 | | -12.46 | 13.02 |
| -11.66 | 38.00 | | -11.66 | 62.00 | | -11.66 | 12.98 |
| -10.86 | 38.00 | | -10.86 | 62.00 | | -10.86 | 12.95 |
| -10.06 | 38.00 | | -10.06 | 62.00 | | -10.06 | 12.91 |
| -9.25 | 38.00 | | -9.25 | 62.00 | | -9.25 | 12.89 |
| -8.45 | 38.00 | | -8.45 | 62.00 | | -8.45 | 12.86 |
| -7.65 | 38.00 | | -7.65 | 62.00 | | -7.65 | 12.84 |
| -6.85 | 38.00 | | -6.85 | 62.00 | | -6.85 | 12.82 |
| -6.05 | 38.00 | | -6.05 | 62.00 | | -6.05 | 12.80 |
| -5.25 | 38.00 | | -5.25 | 62.00 | | -5.25 | 12.78 |
| -4.44 | 38.00 | | -4.44 | 62.00 | | -4.44 | 12.77 |
| -3.64 | 38.00 | | -3.64 | 62.00 | | -3.64 | 12.76 |
| -2.84 | 38.00 | | -2.84 | 62.00 | | -2.84 | 12.75 |
| -2.04 | 38.00 | | -2.04 | 62.00 | | -2.04 | 12.75 |
| -1.24 | 38.00 | | -1.24 | 62.00 | | -1.24 | 12.74 |
| -0.44 | 38.00 | | -0.44 | 62.00 | | -0.44 | 12.74 |
| 0.36 | 38.00 | | 0.36 | 62.00 | | 0.36 | 12.75 |
| 1.17 | 38.00 | | 1.17 | 62.00 | | 1.17 | 12.75 |
| 1.97 | 38.00 | | 1.97 | 62.00 | | 1.97 | 12.76 |
| 2.77 | 38.00 | | 2.77 | 62.00 | | 2.77 | 12.77 |
| 3.57 | 38.00 | | 3.57 | 62.00 | | 3.57 | 12.79 |
| 4.37 | 38.00 | | 4.37 | 62.00 | | 4.37 | 12.80 |
| 5.17 | 38.00 | | 5.17 | 62.00 | | 5.17 | 12.82 |
| 5.98 | 38.00 | | 5.98 | 62.00 | | 5.98 | 12.85 |
| 6.78 | 38.00 | | 6.78 | 62.00 | | 6.78 | 12.87 |
| 7.58 | 38.00 | | 7.58 | 62.00 | | 7.58 | 12.90 |
| 8.38 | 38.00 | | 8.38 | 62.00 | | 8.38 | 12.93 |

(continued)

| Secondary nozzle outer contour | | | Secondary nozzle inner contour | | | Primary nozzle inner contour | |
|---|---|---|---|---|---|---|---|
| 9.18 | 38.00 | | 9.18 | 62.00 | | 9.18 | 12.96 |
| 9.98 | 38.00 | | 9.98 | 62.00 | | 9.98 | 13.00 |
| 10.79 | 38.00 | | 10.79 | 62.00 | | 10.79' | 13.03 |
| 11.59 | 38.00 | | 11.59 | 62.00 | | 11.59 | 13.08 |
| 12.39 | 38.00 | | 12.39 | 62.00 | | 12.39 | 13.12 |
| 13.19 | 38.00 | | 13.19 | 62.00 | | 13.19 | 13.17 |
| 13.99 | 38.00 | | 13.99 | 62.00 | | 13.99 | 13.21 |
| 14.79 | 38.00 | | 14.79 | 62.00 | | 14.79 | 13.27 |
| 15.59 | 38.00 | | 15.59 | 62.00 | | 15.59 | 13.32 |
| 16.40 | 38.00 | | 16.40 | 62.00 | | 16.40 | 13.38 |
| 17.20 | 38.00 | | 17.20 | 62.00 | | 17.20 | 13.44 |
| 18.00 | 38.00 | | 18.00 | 62.00 | | 18.00 | 13.50 |
| 18.80 | 38.00 | | 18.80 | 62.00 | | 18.80 | 13.56 |
| 19.60 | 38.00 | | 19.60 | 62.00 | | 19.60 | 13.63 |
| 20.40 | 38.00 | | 20.40 | 62.00 | | 20.40 | 13.70 |
| 21.21 | 38.00 | | 21.21 | 61.98 | | 21.21 | 13.78 |
| 22.01 | 38.00 | | 22.01 | 61.96 | | 22.01 | 13.85 |
| 22.81 | 38.00 | | 22.81 | 61.92 | | 22.81 | 13.93 |
| 23.61 | 38.00 | | 23.61 | 61.86 | | 23.61 | 14.01 |
| 24.41 | 38.00 | | 24.41 | 61.80 | | 24.41 | 14.10 |
| 25.21 | 38.00 | | 25.21 | 61.72 | | 25.21 | 14.18 |
| 26.02 | 38.00 | | 26.02 | 61.63 | | 26.02 | 14.27 |
| 26.82 | 38.00 | | 26.82 | 61.52 | | 26.82 | 14.37 |
| 27.62 | 38.00 | | 27.62 | 61.40 | | 27.62 | 14.46 |
| 28.42 | 38.00 | | 28.42 | 61.27 | | 28.42 | 14.56 |
| 29.22 | 38.00 | | 29.22 | 61.13 | | 29.22 | 14.65 |
| 30.02 | 38.00 | | 30.02 | 60.97 | | 30.02 | 14.75 |
| 30.82 | 38.00 | | 30.82 | 60.80 | | 30.82' | 14.84 |
| 31.63 | 38.00 | | 31.63 | 60.61 | | 31.63 | 14.94 |
| 32.43 | 38.00 | | 32.43 | 60.41 | | 32.43 | 15.04 |
| 33.23 | 38.00 | | 33.23 | 60.20 | | 33.23 | 15.13 |
| 34.03 | 38.00 | | 34.03 | 59.97 | | 34.03 | 15.22 |
| 34.83 | 38.00 | | 34.83 | 59.73 | | 34.83 | 15.32 |
| 35.63 | 38.00 | | 35.63 | 59.47 | | 35.63 | 15.41 |
| 36.44 | 37.99 | | 36.44 | 59.20 | | 36.44 | 15.50 |
| 37.24 | 37.96 | | 37.24 | 58.91 | | 37.24 | 15.59 |
| 38.04 | 37.92 | | 38.04 | 58.60 | | 38.04 | 15.68 |
| 38.84 | 37.86 | | 38.84 | 58.28 | | 38.84 | 15.76 |

(continued)

| Secondary nozzle outer contour | | | Secondary nozzle inner contour | | | Primary nozzle inner contour | |
|---|---|---|---|---|---|---|---|
| 39.64 | 37.78 | | 39.64 | 57.95 | | 39.64 | 15.85 |
| 40.44 | 37.69 | | 40.44 | 57.60 | | 40.44 | 15.93 |
| 41.25 | 37.58 | | 41.25 | 57.23 | | 41.25 | 16.02 |
| 42.05 | 37.45 | | 42.05 | 56.84 | | 42.05 | 16.10 |
| 42.85 | 37.31 | | 42.85 | 56.44 | | 42.85 | 16.18 |
| 43.65 | 37.15 | | 43.65 | 56.01 | | 43.65 | 16.26 |
| 44.45 | 36.97 | | 44.45 | 55.57 | | 44.45 | 16.33 |
| 45.25 | 36.78 | | 45.25 | 55.11 | | 45.25 | 16.41 |
| 46.05 | 36.57 | | 46.05 | 54.63 | | 46.05 | 16.48 |
| 46.86 | 36.34 | | 46.86 | 54.13 | | 46.86 | 16.55 |
| 47.66 | 36.09 | | 47.66 | 53.60 | | 47.66 | 16.62 |
| 48.46 | 35.83 | | 48.46 | 53.06 | | 48.46 | 16.69 |
| 49.26 | 35.54 | | 49.26 | 52.49 | | 49.26 | 16.76 |
| 50.06 | 35.24 | | 50.06 | 51.90 | | 50.06 | 16.82 |
| 50.86 | 34.91 | | 50.86 | 51.28 | | 50.86 | 16.88 |
| 51.67 | 34.57 | | 51.67 | 50.63 | | 51.67 | 16.94 |
| 52.47 | 34.20 | | 52.47 | 49.96 | | 52.47 | 17.00 |
| 53.27 | 33.81 | | 53.27 | 49.26 | | 53.27 | 17.06 |
| 54.07 | 33.40 | | 54.07 | 48.53 | | 54.07 | 17.12 |
| 54.87 | 32.97 | | 54.87 | 47.76 | | 54.87 | 17.17 |
| 55.67 | 32.51 | | 55.67 | 46.96 | | 55.67 | 17.23 |
| 56.48 | 32.05 | | 56.48 | 46.16 | | 56.48 | 17.28 |
| 57.28 | 31.59 | | 57.28 | 45.36 | | 57.28 | 17.33 |
| 58.08 | 31.13 | | 58.08 | 44.56 | | 58.08 | 17.37 |
| 58.88 | 30.66 | | 58.88 | 43.76 | | 58.88 | 17.42 |
| 59.68 | 30.20 | | 59.68 | 42.96 | | 59.68 | 17.46 |
| 60.48 | 29.74 | | 60.48 | 42.15 | | 60.48 | 17.51 |
| 61.28 | 29.29 | | 61.28 | 41.35 | | 61.28 | 17.55 |
| 62.09 | 28.86 | | 62.09 | 40.55 | | 62.09 | 17.59 |
| 62.89 | 28.45 | | 62.89 | 39.75 | | 62.89 | 17.62 |
| 63.69 | 28.05 | | 63.69 | 38.95 | | 63.69 | 17.66 |
| 64.49 | 27.68 | | 64.49 | 38.15 | | 64.49 | 17.70 |
| 65.29 | 27.32 | | 65.29 | 37.41 | | 65.29 | 17.73 |
| 66.09 | 26.97 | | 66.09 | 36.71 | | 66.09 | 17.76 |
| 66.90 | 26.65 | | 66.90 | 36.06 | | 66.90 | 17.79 |
| 67.70 | 26.34 | | 67.70 | 35.46 | | 67.70 | 17.82 |
| 68.50 | 26.04 | | 68.50 | 34.90 | | 68.50 | 17.85 |
| 69.30 | 25.77 | | 69.30 | 34.37 | | 69.30 | 17.87 |

(continued)

| Secondary nozzle outer contour | | | Secondary nozzle inner contour | | | Primary nozzle inner contour | |
|---|---|---|---|---|---|---|---|
| 70.10 | 25.50 | | 70.10 | 33.88 | | 70.10 | 17.89 |
| 70.90 | 25.25 | | 70.90 | 33.43 | | 70.90 | 17.92 |
| 71.71 | 25.02 | | 71.71 | 33.00 | | 71.71 | 17.94 |
| 72.51 | 24.80 | | 72.51 | 32.61 | | 72.51 | 17.96 |
| 73.31 | 24.59 | | 73.31 | 32.25 | | 73.31 | 17.98 |
| 74.11 | 24.40 | | 74.11 | 31.91 | | 74.11 | 18.00 |
| 74.91 | 24.22 | | 74.91 | 31.60 | | 74.91 | 18.01 |
| 75.71 | 24.06 | | 75.71 | 31.32 | | 75.71 | 18.03 |
| 76.51 | 23.91 | | 76.51 | 31.06 | | 76.51 | 18.04 |
| 77.32 | 23.77 | | 77.32 | 30.82 | | 77.32 | 18.05 |
| 78.12 | 23.65 | | 78.12 | 30.61 | | 78.12 | 18.06 |
| 78.92 | 23.54 | | 78.92 | 30.42 | | 78.92 | 18.07 |
| 79.72 | 23.44 | | 79.72 | 30.26 | | 79.72 | 18.08 |
| 80.52 | 23.36 | | 80.52 | 30.12 | | 80.52 | 18.09 |
| 81.32 | 23.29 | | 81.32 | 30.00 | | 81.32 | 18.10 |
| 82.13 | 23.23 | | 82.13 | 29.90 | | 82.13 | 18.11 |
| 82.93 | 23.18 | | 82.93 | 29.83 | | 82.93 | 18.11 |
| 83.73 | 23.15 | | 83.73 | 29.77 | | 83.73 | 18.12 |
| 84.53 | 23.13 | | 84.53 | 29.74 | | 84.53 | 18.12 |
| 85.33 | 23.13 | | 85.33 | 29.73 | | 85.33 | 18.13 |

**15.** Injector according to claim 14, **characterised in that** the inner contour of the primary nozzle corresponds with the contour determined on a numerical path by a modified characteristic method.

**Revendications**

**1.** Dispositif d'injection pour une utilisation dans des installations métallurgiques, en particulier dans un convertisseur à l'oxygène pur (BOF), dans un convertisseur de décarburation à l'oxygène et l'argon (AOD), ou dans un four à arc électrique (EAF), avec une buse primaire conçue comme une buse supersonique pour souffler un gaz riche en oxygène sur un métal en fusion et une buse secondaire agencée de manière coaxiale à la buse primaire, pour générer un jet coaxial entourant le jet de gaz sortant de la buse primaire, dans lequel la buse primaire comporte une section convergente et une section divergente qui sont adjacentes les unes aux autres suivant un rayon r* de la section transversale la plus étroite, dans lequel, pour la buse primaire, le rapport entre une longueur de la buse l et le rayon de la section transversale la plus étroite r*, à savoir l/r*, est compris entre 2,1 et 11,6 ; préférentiellement entre 2,1 et 8,3 ; plus préférentiellement entre 2,1 et 5,4 ; plus préférentiellement encore entre 2,1 et 5,0 ; et en particulier des valeurs particulières de 11,6 ; 8,3 ; 5,4 ; 5,0 ; 4,8 ; 4,2 ; 4,1 ; 3,6 ; 3,3 ; 3,1 ; ou 2,1 ; **caractérisé en ce que** la buse primaire et la buse secondaire sont définies par l'ensemble des formes de buses suivant leurs configurations respectives :

| buse primaire | | | | | buse secondaire | | |
|---|---|---|---|---|---|---|---|
| Pression $p_0$ [bar] | Débit en volume $v_o$ [Nm$^3$/min] | Rayon dans la section transversale la plus étroite r* [mm] | rayon de sortie $r_1$ [mm] | longueur de la buse l [mm] | Nombre de mach $M_s$[-] | Température $T_s$ [K] | Hauteur de fente coaxiale $H_s$ [mm] |
| 4 | 20 | 12,0 | 14,0 | 50 ±20 | 0,5 ± 0,2 | 1000 ± 200 | 7 ± 3 |
| 4 | 200 | 39 | 44.0 | 160+20 | 0,5 ± 0,2 | 1000 ± 200 | 7 ± 3 |
| 14 | 20 | 6 | 10,0 | 50 ±20 | 0,5 ± 0,2 | 1000 ± 200 | 7 ± 3 |
| 14 | 200 | 21 | 33.0 | 160 ± 20 | 0,5 ± 0,2 | 1000 ± 200 | 7 ± 3 |

**2.** Dispositif d'injection pour une utilisation dans des installations métallurgiques, en particulier dans un convertisseur à l'oxygène pur (BOF), dans un convertisseur de décarburation à l'oxygène et l'argon (AOD), ou dans un four à arc électrique (EAF), avec une buse primaire conçue comme une buse supersonique pour souffler un gaz riche en oxygène sur un métal en fusion et une buse secondaire agencée de manière coaxiale à la buse primaire, pour générer un jet coaxial entourant le jet de gaz sortant de la buse primaire, dans lequel la buse primaire comporte une section convergente et une section divergente qui sont adjacentes les unes aux autres suivant un rayon de la section transversale la plus étroite r*, **caractérisé en ce que** le contour intérieur et le contour extérieur de la buse secondaire est numériquement déterminée de telle sorte que le nombre de Mach convectif $M_{c\infty s}$ entre l'environnement ($\infty$) et le jet secondaire produit par la buse secondaire (s) est égal au nombre de Mach convectif $M_{csp}$ entre le jet secondaire (s) et le jet primaire (p) produit par la buse primaire:

$$M_{c\infty p} = M_{csp},$$

dans lequel la détermination numérique comprend les étapes:

a) détermination des nombres de Mach convectifs:

jet unique (single-jet): $M_{c\infty p}$ entre l'environnement et le jet primaire

$$M_{c\infty p} = \frac{M_p \sqrt{\rho_\infty / \rho_p}}{(1 + \sqrt{\rho_\infty / \rho_p})(\gamma_\infty / \gamma_p)^{1/4}}$$

jet coaxial: $M_{c\infty s}$ entre l'environnement et le jet secondaire et $M_{csp}$ entre le jet secondaire et jet primaire

$$M_{c\infty s} = \frac{M_s \sqrt{\rho_\infty / \rho_s}}{(1 + \sqrt{\rho_\infty / \rho_s})(\gamma_\infty / \gamma_s)^{1/4}} , \qquad M_{csp} = \frac{M_p \sqrt{\rho_s / \rho_p}(1 - u_s / u_p)}{(1 + \sqrt{\rho_s / \rho_p})(\gamma_s / \gamma_p)^{1/4}}$$

b) détermination du paramètre optimal de fonctionnement pour le jet coaxial, valable pour jet primaire froid, jet secondaire chaud et environnement chaud
Nouveau critère d'optimisation:

$$M_{c\infty s} = M_{csp}$$

Nombre de Mach du jet secondaire:

$$M_s = \frac{u_s}{a_s} = \frac{u_p}{a_s}\left[1 + \frac{a_p}{a_s}\left(\frac{1 + \sqrt{\rho_p/\rho_s}}{1 + \sqrt{\rho_s/\rho_\infty}}\right)\left(\frac{\gamma_p\gamma_\infty}{\gamma_s^2}\right)^{-1/4}\right]^{-1}$$

c) détermination du nouveau modèle de corrélation pour le jet coaxial, valable pour jet primaire froid, jet secondaire chaud et environnement chaud.

Fonctions du nombre de Mach convectif:

$$F_{\infty p} = M_{C\infty p}^Z, \qquad F_{sp} = M_{Csp}^Z, \qquad F_{\infty s} = M_{C\infty s}^2,$$

Les fonctions de commutation et de géométrie:

$$F_{\infty sp} = \alpha\left(\frac{F_{sp}F_{\infty s}}{\beta F_{sp} + F_{\infty s}}\right), \quad F_p = 1 + \frac{F_{\infty sp}}{F_{sp}F_{\infty p}}\left(F_{sp} - F_{\infty p}\right), \qquad F_h = 1 + \sigma(H_s/D_p),$$

Fonction de la longueur du jet:

$$\frac{L_p^*}{L_{single}^*} = \varphi F_h \cdot \exp\left[-\theta \cdot abs(F_p)\right]$$

3.  Dispositif d'injection selon la revendication 1 ou 2, **caractérisé en ce que** la buse primaire est destiné à être utilisée avec de l'oxygène et la buse secondaire pour une utilisation avec du $CH_4$ ou GPL.

4.  Dispositif d'injection selon l'une des revendications précédentes, **caractérisé en ce que** la buse secondaire est conçue comme buse subsonique.

5.  Dispositif d'injection selon l'une quelconque des revendications précédentes, **caractérisé en ce qu'**il est prévu un générateur de gaz chaud couplé avec la buse secondaire, produisant un jet secondaire de gaz de combustion chaud par l'intermédiaire de la buse secondaire.

6.  Dispositif d'injection selon la revendication 5, **caractérisé en ce que** le générateur de gaz chaud peut être commandé de manière à ce que la quantité de gaz d'échappement optimale pour le dimensionnement de la buse secondaire et de la buse primaire est atteinte à une température optimale de gaz d'échappement.

7.  Dispositif d'injection selon l'une quelconque des revendications précédentes, **caractérisé en ce que** le contour intérieur de la buse primaire correspond à un contour déterminé numériquement par une méthode des caractéristiques modifiée.

8.  Dispositif d'injection selon l'une quelconque des revendications précédentes, **caractérisé en ce que** le contour intérieur de la buse primaire correspond au contour déterminé par résolution numérique des équations différentielles dynamiques des gaz, dans laquelle le flux gazeux stationnaire, isentropique, symétrique en rotation est présenté au moyen d'équations de caractéristiques discrétisées spatialement en considération de conditions de compatibilité correspondantes.

9.  Dispositif d'injection selon la revendication 8, **caractérisé en ce que**, dans la résolution numérique des équations aux dérivées partielles l'influence d'un écoulement de couche limite à proximité de la paroi et lié au frottement est prise en compte.

**10.** Dispositif d'injection selon l'une quelconque des revendications précédentes, **caractérisé en ce qu'**il comprend, dans la buse primaire de la section convergente, un contour en forme de cloche et la section divergente présente un contour en forme de cloche, dans lequel les contours en forme de cloche de la section convergente et de la section divergente au niveau du col de la buse fusionnent en continu.

**11.** Dispositif d'injection selon l'une des revendications précédentes, **caractérisé en ce que** la buse primaire présente une partie convergente subsonique et une partie supersonique divergente, et le contour intérieur correspond à un contour intérieur déterminé par une méthode des caractéristiques modifiée, ledit contour générant une longue zone supersonique $L^*_p$, et la buse secondaire présente, en partant de celle-ci, un contour intérieur et un contour extérieur d'une forme qui implique numériquement à la fois la géométrie globale et les paramètres de processus thermique des gaz coaxiaux de telle sorte que la longueur supersonique $L^*_p$ du jet primaire est en outre prolongé.

**12.** Dispositif d'injection selon l'une des revendications précédentes, **caractérisé en ce qu'**il peut fonctionner dans un mode injecteur et un mode brûleur, où, dans le mode injecteur, un jet primaire riche en oxygène, enveloppé par un jet secondaire coaxial, peut être appliqué à une masse fondue de métal, et, dans le mode de brûleur, du $CH_4$ ou du GPL, via la buse secondaire, et un gaz riche en oxygène, via la buse primaire, peuvent être alimentés de manière à produire un jet de combustion.

**13.** Dispositif d'injection selon la revendication 12, **caractérisé par** les paramètres de fonctionnement suivants dans le mode injecteur et le mode brûleur:

| Mode injecteur: | pression d'entrée de l'oxygène buse primaire: | $p_0 = 10$ bar |
|---|---|---|
| | débit d'oxygène buse primaire: | $\dot{v} = 50$ Nm³/min |
| | pression ambiante: | $p_\infty = 1,013$ bar |
| Mode brûleur: | puissance du brûleur: | $P = 6,00$ KW |

| Mode injecteur | | | | | | Mode brûleur | | | | | |
|---|---|---|---|---|---|---|---|---|---|---|---|
| jet primaire | | | jet secondaire | | | jet primaire | | | jet secondaire | | |
| $M_p$ | - | 2,149 | $M_s$ | - | 0,482 | P | MW | 6,00 | | | |
| $T_P$ | K | 152,9 | $T_s$ | K | 1100,0 | $\dot{v}_{p,O2}$ | Nm³/h | 1205,6 | $\dot{V}_{s,CH4}$ | Nm³/h | 601,9 |
| $\dot{V}_p$ | Nm³/h | 3000 | $H_s$ | m | 0,00664 | $\dot{m}_{pO2}$ | kg/s | 0,4786 | $\dot{m}_{pCH4}$ | kg/s | 0,120 0 |
| $u_p$ | m/s | 506,2 | $\dot{v}_s$ | Nm³/h | 311,0 | | | | | | |
| $p_p$ | Pa | 101325 | $\dot{v}_{s,CH4}$ | Nm³/h | 11,0 | | | | | | |
| | | | $\dot{v}_{s,air}$ | Nm³/h | 300 | | | | | | |
| | | | $T_{0,s}$ | K | 1144,7 | | | | | | |
| | | | $u_s$ | m/s | 317,8 | | | | | | |
| | | | $p_s$ | Pa | 101325 | | | | | | |
| | | | $\dot{m}_s$ | kg/s | 0,1099 | | | | | | |
| | | | $\dot{m}_{s,CH4}$ | kg/s | 0,0022 | | | | | | |
| | | | $\dot{m}_{s,air}$ | kg/s | 0,1077 | | | | | | |
| | | | $p_{0,s}$ | Pa | 118162 | | | | | | |
| Longueur supersonique: $L^*_{p,unique} = 1,107$ m $L^*_{p,coaxial} = 1,608$ m | | | | | | | | | | | |

**14.** Dispositif d'injection pour une utilisation dans des installations métallurgiques, en particulier dans un convertisseur à l'oxygène pur (BOF), dans un convertisseur de décarburation à l'oxygène et l'argon (AOD), ou dans un four à arc électrique (EAF), avec une buse primaire conçue comme une buse supersonique pour souffler un gaz riche en oxygène sur un métal en fusion et une buse secondaire agencée de manière coaxiale à la buse primaire, pour générer un jet coaxial entourant le jet de gaz sortant de la buse primaire, dans lequel la buse primaire comporte une section convergente et une section divergente qui sont adjacentes les unes aux autres suivant un rayon de la section transversale la plus étroite r*, **caractérisé par** les dimensions suivantes dans la configuration suivante en coordonnées axiale (x) et radiale (r) :

| Injecteur | | | | | | | |
|---|---|---|---|---|---|---|---|
| pression d'entrée d'oxygène buse primaire: $p_0$ = 10 bar débit volumique d'oxygène buse primaire: $\dot{v}_o$ = 50 Nm$^3$ / min pression ambiante: $p\infty$ = 1,013 bar puissance du brûleur: P = 6,00 MW | | | | | | | |
| buse secondaire contour extérieur | | | Buse secondaire contour intérieur | | | buse primaire contour intérieur | |
| x en mm | r en mm | | x en mm | r en mm | | x en mm | r en mm |
| -77,39 | 38,00 | | -77,39 | 62,00 | | -77,39 | 20,02 |
| -76,59 | 38,00 | | -76,59 | 62,00 | | -76,59 | 20,03 |
| -75,79 | 38,00 | | -75,79 | 62,00 | | -75,79 | 20,03 |
| -74,98 | 38,00 | | -74,98 | 62,00 | | -74,98 | 20,02 |
| -74,18 | 38,00 | | -74,18 | 62,00 | | -74,18 | 20,00 |
| -73,38 | 38,00 | | -73,38 | 62,00 | | -73,38 | 19,99 |
| -72,58 | 38,00 | | -72,58 | 62,00 | | -72,58 | 19,96 |
| -71,78 | 38,00 | | -71,78 | 62,00 | | -71,78 | 19,93 |
| -70,98 | 38,00 | | -70,98 | 62,00 | | -70,98 | 19,90 |
| -70,17 | 38,00 | | -70,17 | 62,00 | | -70,17 | 19,87 |
| -69,37 | 38,00 | | -69,37 | 62,00 | | -69,37 | 19,83 |
| -68,57 | 38,00 | | -68,57 | 62,00 | | -68,57 | 19,78 |
| -67,77 | 38,00 | | -67,77 | 62,00 | | -67,77 | 19,73 |
| -66,97 | 38,00 | | -66,97 | 62,00 | | -66,97 | 19,68 |
| -66,17 | 38,00 | | -66,17 | 62,00 | | -66,17 | 19,62 |
| -65,36 | 38,00 | | -65,36 | 62,00 | | -65,36 | 19,56 |
| -64,56 | 38,00 | | -64,56 | 62,00 | | -64,56 | 19,49 |
| -63,76 | 38,00 | | -63,76 | 62,00 | | -63,76 | 19,42 |
| -62,96 | 38,00 | | -62,96 | 62,00 | | -62,96 | 19,35 |
| -62,16 | 38,00 | | -62,16 | 62,00 | | -62,16 | 19,27 |
| -61,36 | 38,00 | | -61,36 | 62,00 | | -61,36 | 19,19 |
| -60,56 | 38,00 | | -60,56 | 62,00 | | -60,56 | 19,10 |
| -59,75 | 38,00 | | -59,75 | 62,00 | | -59,75 | 19,01 |
| -58,95 | 38,00 | | -58,95 | 62,00 | | -58,95 | 18,92 |
| -58,15 | 38,00 | | -58,15 | 62,00 | | -58,15 | 18,82 |
| -57,35 | 38,00 | | -57,35 | 62,00 | | -57,35 | 18,71 |
| -56,55 | 38,00 | | -56,55 | 62,00 | | -56,55 | 18,61 |
| -55,75 | 38,00 | | -55,75 | 62,00 | | -55,75 | 18,49 |
| -54,94 | 38,00 | | -54,94 | 62,00 | | -54,94 | 18,38 |

(suite)

| buse secondaire contour extérieur | | | Buse secondaire contour intérieur | | | buse primaire contour intérieur | |
|---|---|---|---|---|---|---|---|
| x en mm | r en mm | | x en mm | r en mm | | x en mm | r en mm |
| -54,14 | 38,00 | | -54,14 | 62,00 | | -54,14 | 18,26 |
| -53,34 | 38,00 | | -53,34 | 62,00 | | -53,34 | 18,13 |
| -52,54 | 38,00 | | -52,54 | 62,00 | | -52,54 | 18,01 |
| -51,74 | 38,00 | | -51,74 | 62,00 | | -51,74 | 17,87 |
| -50,94 | 38,00 | | -50,94 | 62,00 | | -50,94 | 17,73 |
| -50,13 | 38,00 | | -50,13 | 62,00 | | -50,13 | 17,60 |
| -49,33 | 38,00 | | -49,33 | 62,00 | | -49,33 | 17,46 |
| -48,53 | 38,00 | | -48,53 | 62,00 | | -48,53 | 17,32 |
| -47,73 | 38,00 | | -47,73 | 62,00 | | -47,73 | 17,18 |
| -46,93 | 38,00 | | -46,93 | 62,00 | | -46,93 | 17,05 |
| -46,13 | 38,00 | | -46,13 | 62,00 | | -46,13 | 16,91 |
| -45,33 | 38,00 | | -45,33 | 62,00 | | -45,33 | 16,77 |
| -44,52 | 38,00 | | -44,52 | 62,00 | | -44,52 | 16,63 |
| -43,72 | 38,00 | | -43,72 | 62,00 | | -43,72 | 16,49 |
| -42,92 | 38,00 | | -42,92 | 62,00 | | -42,92 | 16,35 |
| -42,12 | 38,00 | | -42,12 | 62,00 | | -42,12 | 16,22 |
| -41,32 | 38,00 | | -41,32 | 62,00 | | -41,32 | 16,08 |
| -40,52 | 38,00 | | -40,52 | 62,00 | | -40,52 | 15,95 |
| -39,71 | 38,00 | | -39,71 | 62,00 | | -39,71 | 15,82 |
| -38,91 | 38,00 | | -38,91 | 62,00 | | -38,91 | 15,70 |
| -38,11 | 38,00 | | -38,11 | 62,00 | | -38,11 | 15,57 |
| -37,31 | 38,00 | | -37,31 | 62,00 | | -37,31 | 15,45 |
| -36,51 | 38,00 | | -36,51 | 62,00 | | -36,51 | 15,33 |
| -35,71 | 38,00 | | -35,71 | 62,00 | | -35,71 | 15,22 |
| -34,90 | 38,00 | | -34,90 | 62,00 | | -34,90 | 15,10 |
| -34,10 | 38,00 | | -34,10 | 62,00 | | -34,10 | 14,99 |
| -33,30 | 38,00 | | -33,30 | 62,00 | | -33,30 | 14,89 |
| -32,50 | 38,00 | | -32,50 | 62,00 | | -32,50 | 14,78 |
| -31,70 | 38,00 | | -31,70 | 62,00 | | -31,70 | 14,68 |
| -30,90 | 38,00 | | -30,90 | 62,00 | | -30,90 | 14,58 |
| -30,10 | 38,00 | | -30,10 | 62-00 | | -30,10 | 14,48 |
| -29,29 | 38,00 | | -29,29 | 62,00 | | -29,29 | 14,39 |
| -28,49 | 38,00 | | -28,49 | 62,00 | | -28,49 | 14,30 |
| -27,69 | 38,00 | | -27,69 | 62,00 | | -27,69 | 14,21 |
| -26,89 | 38,00 | | -26,89 | 62,00 | | -26,89 | 14,12 |
| -26,09 | 38,00 | | -26,09 | 62,00 | | -26,09 | 14,04 |
| -25,29 | 38,00 | | -25,29 | 62,00 | | -25,29 | 13,96 |

(suite)

| buse secondaire contour extérieur | | | Buse secondaire contour intérieur | | | buse primaire contour intérieur | |
|---|---|---|---|---|---|---|---|
| x en mm | r en mm | | x en mm | r en mm | | x en mm | r en mm |
| -24,48 | 38,00 | | -24,48 | 62,00 | | -24,48 | 13,88 |
| -23,68 | 38,00 | | -23,68 | 62,00 | | -23,68 | 13,80 |
| -22,88 | 38,00 | | -22,88 | 62,00 | | -22,88 | 13,73 |
| -22,08 | 38,00 | | -22,08 | 62,00 | | -22,08 | 13,66 |
| -21,28 | 38,00 | | -21,28 | 62,00 | | -21,28 | 13,59 |
| -20,48 | 38,00 | | -20,48 | 62,00 | | -20,48 | 13,52 |
| -19,67 | 38,00 | | -19,67 | 62,00 | | -19,67 | 13,46 |
| -18,87 | 38,00 | | -18,87 | 62,00 | | -18,87 | 13,40 |
| -18,07 | 38,00 | | -18,07 | 62,00 | | -18,07 | 13,34 |
| -17,27 | 38,00 | | -17,27 | 62,00 | | -17,27 | 13,29 |
| -16,47 | 38,00 | | -16,47 | 62,00 | | -16,47 | 13,24 |
| -15,67 | 38,00 | | -15,67 | 62,00 | | -15,67 | 13,19 |
| -14,87 | 38,00 | | -14,87 | 62,00 | | -14,87 | 13,14 |
| -14,06 | 38,00 | | -14,06 | 62,00 | | -14,06 | 13,10 |
| -13,26 | 38,00 | | -13,26 | 62,00 | | -13,26 | 13,05 |
| -12,46 | 38,00 | | -12,46 | 62,00 | | -12,46 | 13,02 |
| -11,66 | 38,00 | | -11,66 | 62,00 | | -11,66 | 12,98 |
| -10,86 | 38,00 | | -10,86 | 62,00 | | -10,86 | 12,95 |
| -10,06 | 38,00 | | -10,06 | 62,00 | | -10,06 | 12,91 |
| -9,25 | 38,00 | | -9,25 | 62,00 | | -9,25 | 12,89 |
| -8,45 | 38,00 | | -8,45 | 62,00 | | -8,45 | 12,86 |
| -7,65 | 38,00 | | -7,65 | 62,00 | | -7,65 | 12,84 |
| -6,85 | 38,00 | | -6,85 | 62,00 | | -6,85 | 12,82 |
| -6,05 | 38,00 | | -6,05 | 62,00 | | -6,05 | 12,80 |
| -5,25 | 38,00 | | -5,25 | 62,00 | | -5,25 | 12,78 |
| -4,44 | 38,00 | | -4,44 | 62,00 | | -4,44 | 12,77 |
| -3,64 | 38,00 | | -3,64 | 62,00 | | -3,64 | 12,76 |
| -2,84 | 38,00 | | -2,84 | 62,00 | | -2,84 | 12,75 |
| -2,04 | 38,00 | | -2,04 | 62,00 | | -2,04 | 12,75 |
| -1,24 | 38,00 | | -1,24 | 62,00 | | -1,24 | 12,74 |
| -0,44 | 38,00 | | -0,44 | 62,00 | | -0,44 | 12,74 |
| 0,36 | 38,00 | | 0,36 | 62,00 | | 0,36 | 12,75 |
| 1,17 | 38,00 | | 1,17 | 62,00 | | 1,17 | 12,75 |
| 1,97 | 38,00 | | 1,97 | 62,00 | | 1,97 | 12,76 |
| 2,77 | 38,00 | | 2,77 | 62,00 | | 2,77 | 12,77 |
| 3,57 | 38,00 | | 3,57 | 62,00 | | 3,57 | 12,79 |
| 4,37 | 38,00 | | 4,37 | 62,00 | | 4,37 | 12,80 |

(suite)

| buse secondaire contour extérieur | | Buse secondaire contour intérieur | | | buse primaire contour intérieur | |
|---|---|---|---|---|---|---|
| x en mm | r en mm | x en mm | r en mm | | x en mm | r en mm |
| 5,17 | 38,00 | 5,17 | 62,00 | | 5,17 | 12,82 |
| 5,98 | 38,00 | 5,98 | 62,00 | | 5,98 | 12,85 |
| 6,78 | 38,00 | 6,78 | 62,00 | | 6,78 | 12,87 |
| 7,58 | 38,00 | 7,58 | 62,00 | | 7,58 | 12,90 |
| 8,38 | 38,00 | 8,38 | 62,00 | | 8,38 | 12,93 |
| 9,18 | 38,00 | 9,18 | 62,00 | | 9,18 | 12,96 |
| 9,98 | 38,00 | 9,98 | 62,00 | | 9,98 | 13,00 |
| 10,79 | 38,00 | 10,79 | 62,00 | | 10,79 | 13,03 |
| 11,59 | 38,00 | 11,59 | 62,00 | | 11,59 | 13,08 |
| 12,39 | 38,00 | 12,39 | 62,00 | | 12,39 | 13,12 |
| 13,19 | 38,00 | 13,19 | 62,00 | | 13,19 | 13,17 |
| 13,99 | 38,00 | 13,99 | 62,00 | | 13,99 | 13,21 |
| 14,79 | 38,00 | 14,79 | 62,00 | | 14,79 | 13,27 |
| 15,59 | 38,00 | 15,59 | 62,00 | | 15,59 | 13,32 |
| 16,40 | 38,00 | 16,40 | 62,00 | | 16,40 | 13,38 |
| 17,20 | 38,00 | 17,20 | 62,00 | | 17,20 | 13,44 |
| 18,00 | 38,00 | 18,00 | 62,00 | | 18,00 | 13,50 |
| 18,80 | 38,00 | 18,80 | 62,00 | | 18,80 | 13,56 |
| 19,60 | 38,00 | 19,60 | 62,00 | | 19,60 | 13,63 |
| 20,40 | 38,00 | 20,40 | 62,00 | | 20,40 | 13,70 |
| 21,21 | 38,00 | 21,21 | 61,98 | | 21,21 | 13,78 |
| 22,01 | 38,00 | 22,01 | 61,96 | | 22,01 | 13,85 |
| 22,81 | 38,00 | 22,81 | 61,92 | | 22,81 | 13,93 |
| 23,61 | 38,00 | 23,61 | 61,86 | | 23,61 | 14,01 |
| 24,41 | 38,00 | 24,41 | 61,80 | | 24,41 | 14,10 |
| 25,21 | 38,00 | 25,21 | 61,72 | | 25,21 | 14,18 |
| 26,02 | 38,00 | 26,02 | 61,63 | | 26,02 | 14,27 |
| 26,82 | 38,00 | 26,82 | 61,52 | | 26,82 | 14,37 |
| 27,62 | 38,00 | 27,62 | 61,40 | | 27,62 | 14,46 |
| 28,42 | 38,00 | 28,42 | 61,27 | | 28,42 | 14,56 |
| 29,22 | 38,00 | 29,22 | 61,13 | | 29,22 | 14,65 |
| 30,02 | 38,00 | 30,02 | 60,97 | | 30,02 | 14,75 |
| 30,82 | 38,00 | 30,82 | 60,80 | | 30,82 | 14,84 |
| 31,63 | 38,00 | 31,63 | 60,61 | | 31,63 | 14,94 |
| 32,43 | 38,00 | 32,43 | 60,41 | | 32,43 | 15,04 |
| 33,23 | 38,00 | 33,23 | 60,20 | | 33,23 | 15,13 |
| 34,03 | 38,00 | 34,03 | 59,97 | | 34,03 | 15,22 |

(suite)

| buse secondaire contour extérieur | | | Buse secondaire contour intérieur | | | buse primaire contour intérieur | |
|---|---|---|---|---|---|---|---|
| x en mm | r en mm | | x en mm | r en mm | | x en mm | r en mm |
| 34,83 | 38,00 | | 34,83 | 59,73 | | 34,83 | 15,32 |
| 35,63 | 38,00 | | 35,63 | 59,47 | | 35,63 | 15,41 |
| 36,44 | 37,99 | | 36,44 | 59,20 | | 36,44 | 15,50 |
| 37,24 | 37,96 | | 37,24 | 58,91 | | 37,24 | 15,59 |
| 38,04 | 37,92 | | 38,04 | 58,60 | | 38,04 | 15,68 |
| 38,84 | 37,86 | | 38,84 | 58,28 | | 38,84 | 15,76 |
| 39,64 | 37,78 | | 39,64 | 57,95 | | 39,64 | 15,85 |
| 40,44 | 37,69 | | 40,44 | 57,60 | | 40,44 | 15,93 |
| 41,25 | 37,58 | | 41,25 | 57,23 | | 41,25 | 16,02 |
| 42,05 | 37,45 | | 42,05 | 56,84 | | 42,05 | 16,10 |
| 42,85 | 37,31 | | 42,85 | 56,44 | | 42,85 | 16,18 |
| 43,65 | 37,15 | | 43,65 | 56,01 | | 43,65 | 16,26 |
| 44,45 | 36,97 | | 44,45 | 55,57 | | 44,45 | 16,33 |
| 45,25 | 36,78 | | 45,25 | 55,11 | | 45,25 | 16,41 |
| 46,05 | 36,57 | | 46,05 | 54,63 | | 46,05 | 16,48 |
| 46,86 | 36,34 | | 46,86 | 54,13 | | 46,86 | 16,55 |
| 47,66 | 36,09 | | 47,66 | 53,60 | | 47,66 | 16,62 |
| 48,46 | 35,83 | | 48,46 | 53,06 | | 48,46 | 16,69 |
| 49,26 | 35,54 | | 49,26 | 52,49 | | 49,26 | 16,76 |
| 50,06 | 35,24 | | 50,06 | 51,90 | | 50,06 | 16,82 |
| 50,86 | 34,91 | | 50,86 | 51,28 | | 50,86 | 16,88 |
| 51,67 | 34,57 | | 51,67 | 50,63 | | 51,67 | 16,94 |
| 52,47 | 34,20 | | 52,47 | 49,96 | | 52,47 | 17,00 |
| 53,27 | 33,81 | | 53,27 | 49,26 | | 53,27 | 17,06 |
| 54,07 | 33,40 | | 54,07 | 48,53 | | 54,07 | 17,12 |
| 54,87 | 32,97 | | 54,87 | 47,76 | | 54,87 | 17,17 |
| 55,67 | 32,51 | | 55,67 | 46,96 | | 55,67 | 17,23 |
| 56,48 | 32,05 | | 56,48 | 46,16 | | 56,48 | 17,28 |
| 57,28 | 31,59 | | 57,28 | 45,36 | | 57,28 | 17,33 |
| 58,08 | 31,13 | | 58,08 | 44,56 | | 58,08 | 17,37 |
| 58,88 | 30,66 | | 58,88 | 43,76 | | 58,88 | 17,42 |
| 59,68 | 30,20 | | 59,68 | 42,96 | | 59,68 | 17,46 |
| 60,48 | 29,74 | | 60,48 | 42,15 | | 60,48 | 17,51 |
| 61,28 | 29,29 | | 61,28 | 41,35 | | 61,28 | 17,55 |
| 62,09 | 28,86 | | 62,09 | 40,55 | | 62,09 | 17,59 |
| 62,89 | 28,45 | | 62,89 | 39,75 | | 6289 | 17,62 |
| 63,69 | 28,05 | | 63,69 | 38,95 | | 63,69 | 17,66 |

(suite)

| buse secondaire contour extérieur | | | Buse secondaire contour intérieur | | | buse primaire contour intérieur | |
|---|---|---|---|---|---|---|---|
| x en mm | r en mm | | x en mm | r en mm | | x en mm | r en mm |
| 64,49 | 27,68 | | 64,49 | 38,15 | | 64,49 | 17,70 |
| 65,29 | 27,32 | | 65,29 | 37,41 | | 65,29 | 17,73 |
| 66,09 | 26,97 | | 66,09 | 36,71 | | 66,09 | 17,76 |
| 66,90 | 26,65 | | 66,90 | 36,06 | | 66,90 | 17,79 |
| 67,70 | 26,34 | | 67,70 | 35,46 | | 67,70 | 17,82 |
| 68,50 | 26,04 | | 68,50 | 34,90 | | 68,50 | 17,85 |
| 69,30 | 25,77 | | 69,30 | 34,37 | | 69,30 | 17,87 |
| 70,10 | 25,50 | | 70,10 | 33,88 | | 70,10 | 17,89 |
| 70,90 | 25,25 | | 70,90 | 33,43 | | 70,90 | 17,92 |
| 71,71 | 25,02 | | 71,71 | 33,00 | | 71,71 | 17,94 |
| 72,51 | 24,80 | | 72,51 | 32,61 | | 72,51 | 17,96 |
| 73,31 | 24,59 | | 73,31 | 32,25 | | 73,31 | 17,98 |
| 74,11 | 24,40 | | 74,11 | 31,91 | | 74,11 | 18,00 |
| 74,91 | 24,22 | | 74,91 | 31,60 | | 74,91 | 18,01 |
| 75,71 | 24,06 | | 75,71 | 31,32 | | 75,71 | 18,03 |
| 76,51 | 23,91 | | 76,51 | 31,06 | | 76,51 | 18,04 |
| 77,32 | 23,77 | | 77,32 | 30,82 | | 77,32 | 18,05 |
| 78,12 | 23,65 | | 78,12 | 30,61 | | 78,12 | 18,06 |
| 78,92 | 23,54 | | 78,92 | 30,42 | | 78,92 | 18,07 |
| 79,72 | 23,44 | | 79,72 | 30,26 | | 79,72 | 18,08 |
| 80,52 | 23,36 | | 80,52 | 30,12 | | 80,52 | 18,09 |
| 81,32 | 23,29 | | 81,32 | 30,00 | | 81,32 | 18,10 |
| 82,13 | 23,23 | | 82,13 | 29,90 | | 82,13 | 18,11 |
| 82,93 | 23,18 | | 82,93 | 29,83 | | 82,93 | 18,11 |
| 83,73 | 23,15 | | 83,73 | 29,77 | | 83,73 | 18,12 |
| 84,53 | 23,13 | | 84,53 | 29,74 | | 84,53 | 18,12 |
| 85,33 | 23,13 | | 85,33 | 29,73 | | 85,33 | 18,13 |

**15.** Dispositif d'injection selon la revendication 14, dans lequel le contour intérieur de la buse primaire correspond au contour déterminé numériquement par une méthode des caractéristiques modifiée.

Bild 1

# Bild 2a          # Bild 2b          # Bild 2c

2a-1   2a-2   2a-3

2b-1

2c-1   2c-2   2c-3   2c-4

# Bild 3a

<u>3a-1</u>

<u>3a-5</u>

$P_{0,ox}$ $\dot{V}_{0,ox}$

p

$d^*$    $d_1$

<u>3a-4</u>

<u>3a-3</u>    <u>3a-2</u>

# Bild 3b

<u>3b-5</u>

$P_{0,ox}$ $\dot{V}_{0,ox}$

p

3b-4

3b-3  3b-2  3b-1

r

4-1    4-2

4-3

4-4    4-5

4-6    4-7

4-9

4-8    x

# Bild 4

Bild 5

Bild 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011120976 A1

- WO 201120976 A1

**In der Beschreibung aufgeführte Nicht-Patentliteratur**

- **MURAKAMI E. ; PAPAMOSCHOU, D.:.** Mean flow development in dual-stream compressible jets. The American Institute of Aeronautics and Astronautics (AIAA), 2002, vol. 40, 1131-1138